(19) Europäisches Patentamt
European Patent Office
Office européen des brevets

(11) EP 3 654 102 A1

(12) # EUROPEAN PATENT APPLICATION
published in accordance with Art. 153(4) EPC

(43) Date of publication:
**20.05.2020 Bulletin 2020/21**

(21) Application number: **17917791.0**

(22) Date of filing: **20.12.2017**

(51) Int Cl.:
***G03F 7/11*** *(2006.01)*

(86) International application number:
**PCT/JP2017/045804**

(87) International publication number:
**WO 2019/012716 (17.01.2019 Gazette 2019/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **13.07.2017 JP 2017137452**

(71) Applicant: **Oji Holdings Corporation**
**Chuo-ku**
**Tokyo 104-0061 (JP)**

(72) Inventors:
- **HATTORI, Kimiko**
  **Tokyo 104-0061 (JP)**
- **MORITA, Kazuyo**
  **Tokyo 104-0061 (JP)**

(74) Representative: **Hoffmann Eitle**
**Patent- und Rechtsanwälte PartmbB**
**Arabellastraße 30**
**81925 München (DE)**

(54) # UNDERLAYER FILM-FORMING COMPOSITION, PATTERN-FORMING METHOD, AND COPOLYMER FOR FORMING UNDERLAYER FILM USED FOR PATTERN FORMATION

(57) The present invention provides an underlayer film-forming composition in which the material used is dissolved in an organic solvent, and which is capable of forming an underlayer film that is not prone to cracking under the atmosphere and by heat treatment at a relatively low temperature and which is increasing the coated film residual rate upon forming the underlayer film.
An underlayer film-forming composition for forming an underlayer film used for pattern formation, which comprises a copolymer and an organic solvent;
the copolymer comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and the polymer moiety (b) comprises no saccharide derivative moiety.



Printed by Jouve, 75001 PARIS (FR)

## Description

### Technical Field

The present invention relates to an underlayer film-forming composition, a pattern-forming method, and a copolymer for forming an underlayer film used for pattern formation.

### Background Art

Electronic devices, such as semiconductors, are required to be highly integrated by finer design, and finer designs and diversified shapes have been studied for semiconductor device patterns. A method known in the art for forming such a pattern includes a pattern-forming method by a lithography process using a photoresist. The pattern-forming method by a lithography process using a photoresist is a processing method for forming fine asperities on a surface of a substrate by forming a thin film of a photoresist on a semiconductor substrate, such as a silicon wafer; and etching the substrate using a photoresist pattern as a protective film, the photoresist pattern obtained by irradiating an actinic ray, such as an ultraviolet ray, through a mask pattern on which a semiconductor device pattern is drawn, and developing, to form fine asperities corresponding to the above pattern on the surface of the substrate.

To form a fine pattern, a method involving coating an underlayer film-forming composition on a substrate to form an underlayer film, and then forming a pattern on the underlayer film, has been proposed.

For example, Patent Document 1 describes a resist underlayer film-forming composition containing (A) polysiloxane and (B) a solvent, (B) the solvent containing (B1) a tertiary alcohol. Patent Document 2 describes a method for forming a resist underlayer film, the method including: coating a resist underlayer film-forming composition to a substrate; and heating the resulting coated film at a temperature of higher than 450°C and 800°C or lower in an ambient atmosphere having an oxygen concentration of less than 1 vol.%; wherein the resist underlayer film-forming composition contains a compound including an aromatic ring.

### Citation List

### Patent Documents

Patent Document 1: JP 2016-170338 A
Patent Document 2: JP 2016-206676 A
Patent Document 3: WO 2005/043248
Patent Document 4: JP 2007-256773

### Summary of Invention

### Technical Problem

The underlayer film-forming composition containing polysiloxane described in Patent Document 1 is prone to generate cracking in the underlayer film by heat treatment after the coating and thus has been difficult to use. The underlayer film-forming composition containing a compound including an aromatic ring described in Patent Document 2 requires special conditions in the heat treatment after the coating and thus has been difficult to use.

In contrast, another method known in the art uses a material including a saccharide derivative moiety in an underlayer film-forming composition and forming an underlayer film by heat treatment after the coating.

For example, Patent Document 3 describes an underlayer film-forming composition containing a dextrin ester compound wherein 50% or greater of dextrins are esterified, a cross-linking compound, and an organic solvent.

Patent Document 4 describes an underlayer film-forming composition for lithography, the underlayer film-forming composition containing a cyclodextrin containing an inclusion molecule.

In an attempt to form an underlayer film using a material including a saccharide derivative moiety described in Patent Documents 3 and 4, the present inventors have found that the underlayer film was successfully formed under the atmosphere and by heating at a relatively low temperature, and the difficulties in use described in Patent Documents 1 and 2 have been resolved.

On the other hand, the material used for the underlayer film-forming composition needs to have increased solubility in an organic solvent to form a coated film and also needs to be hardly dissolved in an organic solvent contained in a resist-forming composition or the like after the coated film is heat-treated to form the underlayer film (i.e., the coated

film residual rate of the material used for the underlayer film-forming composition is high). The high solubility of the material used in the underlayer film-forming composition in the organic solvent and the high coated film residual rate after the coated film is heat-treated to form the underlayer film are conflicting performances, and thus in reality achieving both performances has been difficult.
Under such circumstances, the present inventors investigated the underlayer film-forming composition described in Patent Documents 3 and 4, in which a material including a saccharide derivative moiety is used, and found a problem that the composition has low solubility in an organic solvent.

An object of the present invention is to provide an underlayer film-forming composition in which the material used is dissolved in an organic solvent, and which is capable of forming an underlayer film that is not prone to cracking under the atmosphere and by heat treatment at a relatively low temperature and increasing the coated film residual rate upon forming the underlayer film.

## Solution to Problem

As a result of diligent research to achieve the object described above, the present inventors have found that using a copolymer, containing a polymer moiety (unit) including a saccharide moiety and a polymer moiety (unit) including no saccharide moiety, as a material for an underlayer film-forming composition results in obtaining an underlayer film-forming composition in which the material is dissolved in an organic solvent, and which is capable of increasing the coated film residual rate upon forming the underlayer film.
Specifically, the present invention and the preferred aspect of the present invention includes the following constitutions.

(1) An underlayer film-forming composition for forming an underlayer film used for pattern formation, which comprises a copolymer and an organic solvent;
the copolymer comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and
the polymer moiety (b) comprises no saccharide derivative moiety.
(2) The underlayer film-forming composition according to (1), wherein the saccharide derivative moiety is a cellulose derivative moiety, a hemicellulose derivative moiety, or a xylooligosaccharide derivative moiety.
(3) The underlayer film-forming composition according to (1) or (2), which further comprises a saccharide derivative.
(4) The underlayer film-forming composition according to any one of (1) to (3), which further comprises a cross-linking compound.
(5) The underlayer film-forming composition according to any one of (1) to (4), which further comprises an anti-light-reflection agent.
(6) The underlayer film-forming composition according to any one of (1) to (5), which further comprises introducing a metal when used for the pattern formation.
(7) A pattern-forming method which comprises forming an underlayer film using the underlayer film-forming composition described in any one of (1) to (6).
(8) The pattern-forming method according to (7), which further comprises introducing a metal into the underlayer film.
(9) A copolymer for forming an underlayer film used for pattern formation, which comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and
the polymer moiety (b) comprises no saccharide derivative moiety.

## Advantageous Effects of Invention

The present invention can provide an underlayer film-forming composition in which the material used is dissolved in an organic solvent, and which is capable of forming an underlayer film that is not prone to cracking under the atmosphere and by heat treatment at a relatively low temperature, and which is capable of increasing the coated film residual rate upon forming the underlayer film. Description of Embodiments

Hereinafter, the present invention will be described in detail. The description of the constitution requirements below may be made based on the representative embodiments and specific examples, but the present invention is not limited to such embodiments. Note that, in the present specification, a substituent that is not specified whether it is substituted or unsubstituted means that the substituent may include any substituent. In addition, in the present specification, "(meth)acrylate" means including both "acrylate" and "methacrylate".

Underlayer film-forming composition

An underlayer film-forming composition for forming an underlayer film used for pattern formation, which comprises a copolymer and an organic solvent;

the copolymer comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and
the polymer moiety (b) comprises no saccharide derivative moiety.

In an embodiment of the present specification, the underlayer film is a layer provided under a resist film provided on a substrate. That is, the underlayer film is a layer provided between the substrate and the resist film. The underlayer film-forming composition of the present invention is a composition used to form such an underlayer film.

In the underlayer film-forming composition according to an embodiment of the present invention, the solubility of the copolymer in the organic solvent is increased by using a copolymer including the above constitution. That is, this prevents the copolymer from remaining undissolved in the underlayer film-forming composition. In addition, the underlayer film-forming composition according to an embodiment of the present invention can form an underlayer film that is not prone to cracking under the atmosphere and by heat treatment at a relatively low temperature and can increase the coated film residual rate upon forming the underlayer film.

The saccharide derivative moiety includes many cross-linking reaction moieties, and this tends to promote cross-linking by heating (regardless of the addition of a cross-linking agent). Thus, the copolymer, used as the material of the underlayer film-forming composition, including the saccharide derivative moiety, can increase the coated film residual rate after the coated film is heat-treated to form the underlayer film. That is, after the coated film formed from the underlayer film-forming composition is heat-treated to form the underlayer film, the solubility of the copolymer in the organic solvent can be reduced. On the other hand, the copolymer including the polymer moiety (b), which includes no saccharide derivative moiety, can have higher hydrophobicity than a homopolymer of the polymer moiety a, which includes a saccharide derivative moiety, and thus can increase the solubility of the copolymer in the organic solvent.

Note that the underlayer film-forming composition is preferably formed of an organic material, which is preferred in terms of achieving better adhesion with the upper layer organic-based resist material than in case where the underlayer film-forming composition contains an organic-inorganic hybrid material, such as polysiloxane.

The underlayer film-forming composition is a composition for forming an underlayer film used for pattern formation, and the pattern formation from such a composition preferably includes introducing a metal during the pattern formation and in this case more preferably includes introducing a metal into the underlayer film. Note that the object into which a metal is introduced in the introduction of a metal is not limited to the underlayer film, and a metal may be introduced into an underlayer film-forming composition before forming the underlayer film.

Note that, in the present specification, the "polymer moiety" included in the copolymer may be a moiety formed by polymerization of a monomer that forms the copolymer or may be a unit derived from a monomer that forms the copolymer (a repeating unit constituting the polymer (i.e., also referred to as a monomer unit)). That is, the underlayer film-forming composition according to an embodiment of the present invention can also be described as a composition for forming an underlayer film used for pattern formation, the composition containing a copolymer and an organic solvent; the copolymer containing a unit (a) derived from a monomer including a saccharide derivative moiety and a unit (b) derived from a monomer including no saccharide derivative moiety; and the saccharide derivative moiety in the unit (a) being at least one of a pentose derivative moiety or a hexose derivative moiety.

Copolymer

The present invention also relates to a copolymer for forming an underlayer film used for pattern formation, the copolymer which comprises a polymer moiety (a) and a polymer moiety (b). Here, in the copolymer for forming an underlayer film used for pattern formation, the polymer moiety (a) includes a saccharide derivative moiety, and the saccharide derivative moiety is at least one of a pentose derivative moiety or a hexose derivative moiety. In addition, the polymer moiety (b) includes no saccharide derivative moiety.

The underlayer film-forming composition according to an embodiment of the present invention contains a copolymer, and the copolymer contains a polymer moiety (a) and a polymer moiety (b). The sequence of the copolymer is not particularly limited, and the copolymer may be a block copolymer or a random copolymer.

When the copolymer is a block copolymer, the copolymer is preferably an A-B diblock copolymer including the polymer moiety (a) and the polymer moiety (b), but the copolymer may be a block copolymer including a plurality of the polymer moieties a and the polymer moieties (b) each (for example, A-B-A-B).

The polymer moiety (a) of the copolymer preferably has high hydrophilicity, and the polymer moiety (b) preferably

has high hydrophobicity. In addition, the copolymer containing the saccharide derivative moiety which is capable of exhibiting the hydrophilicity of the polymer moiety (a) in an appropriate range, can further increase the solubility of the copolymer in the organic solvent (hereinafter, also referred to as "copolymer solubility").

Note that the copolymer is preferably formed of an organic material in terms of achieving better adhesion with the upper layer organic-based resist material than if the copolymer contained an organic-inorganic hybrid material, such as polysiloxane.

Polymer moiety (a)

In an embodiment of the present invention, the polymer moiety (a) includes a saccharide derivative moiety, and the saccharide derivative moiety is at least one of a pentose derivative moiety or a hexose derivative moiety. As described above, a saccharide derivative moiety including many oxygen atoms is introduced into the polymer moiety (a) of the copolymer, and this forms a structure readily coordinating to a metal. Thus, a metal can be introduced into any of the copolymer, the underlayer film-forming composition, or the underlayer film formed from the underlayer film-forming composition by a simple method, such as a sequential permeation synthesis method, and as a result, the etching resistance can be increased. That is, the underlayer film into which the metal is introduced can become a higher performance mask in the lithography process.

The saccharide derivative moiety included in the polymer moiety (a) may be a saccharide derivative moiety derived from a monosaccharide or may have a structure in which a plurality of saccharide derivative moieties derived from a monosaccharide are bonded together. The saccharide derivative moiety included in the polymer moiety (a) preferably has a structure in which a plurality of saccharide derivative moieties derived from a monosaccharide are bonded together in terms of increasing the metal introduction rate.

The polymer moiety (a) may consist only of a constituent unit including a saccharide derivative moiety or may include a constituent unit including a saccharide derivative moiety and an additional constituent unit. For the polymer moiety (a) including a constituent unit including a saccharide derivative moiety and an additional constituent unit, the additional constituent unit is preferably a constituent unit that is more hydrophilic than the polymer moiety (b).
For the polymer moiety (a) including a constituent unit including a saccharide derivative moiety and an additional constituent unit, the sequences of the constituent unit including a saccharide derivative moiety and the additional constituent unit are not limited to a particular type, and they may be block copolymers or random copolymers. In terms of increasing the solubility in the organic solvent, the constituent unit including a saccharide derivative moiety and the additional constituent unit are preferably block copolymers, and in terms of ease of promoting cross-linking, they are preferably random copolymers. Thus, the structure can be appropriately selected according to the application and the physical properties required.

Saccharide derivative moiety

In an embodiment of the present invention, the saccharide derivative moiety is at least one of a pentose derivative moiety or a hexose derivative moiety.
The pentose derivative moiety is not particularly limited as long as the pentose derivative moiety has a structure derived from a pentose in which a hydroxyl group of a pentose of a well-known monosaccharide or a polysaccharide is modified with at least a substituent. The pentose derivative moiety is preferably a hemicellulose derivative, a xylose derivative moiety, and a xylooligosaccharide derivative moiety, and more preferably a xylooligosaccharide derivative moiety. The hexose derivative moiety is not particularly limited as long as the hexose derivative moiety has a structure derived from a hexose in which a hydroxyl group of a hexose of a well-known monosaccharide or polysaccharide is modified with at least a substituent. The hexose derivative moiety is preferably a glucose derivative moiety and a cellulose derivative moiety, and more preferably a cellulose derivative moiety.
In the present invention, the saccharide derivative moiety is preferably a cellulose derivative moiety, a hemicellulose derivative moiety, or a xylooligosaccharide derivative moiety.

In a constituent unit including the saccharide derivative moiety, the side chain may include the saccharide derivative moiety, or the main chain may include the saccharide derivative moiety. For the side chain including a saccharide derivative moiety, the polymer moiety (a) preferably includes a structure represented by General Formula (1) below. For the main chain including a saccharide derivative moiety, the polymer moiety (a) preferably includes a structure represented by General Formula (2) below. Among them, in the constituent unit including a saccharide derivative moiety, preferably the side chain includes the saccharide derivative moiety from the perspective that the saccharide chain is unlikely to be too long, and the solubility of the copolymer in the organic solvent is easily increased. Note that, in General Formulas (1) and (2), the structure of the saccharide derivative moiety is described as a ring structure, but the structure of the saccharide derivative moiety may be not only a ring structure but also a ring-opened structure (chain structure) called an aldose or a ketose.

In an embodiment of the present invention, the polymer moiety (a) preferably includes at least one structure selected from structures represented by General Formulas (1) or (2).
Hereinafter, preferred ranges of the structures represented by General Formulas (1) and (2) will be described.

[Chem. 1]

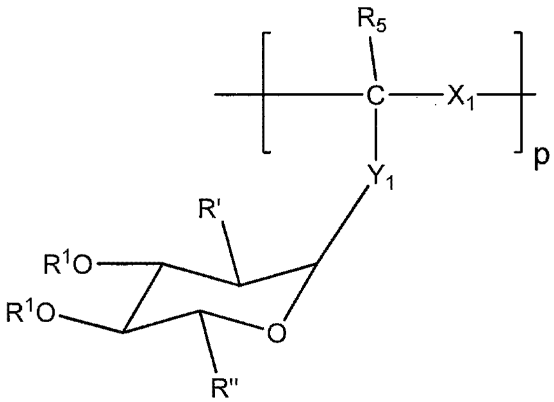

General Formula (1)

In General Formula (1), $R^1$ each independently represents a hydrogen atom, a fluorine atom, a chlorine atom, a bromine atom, an iodine atom, an alkyl group, an acyl group, an aryl group, and a phosphoryl group, where the alkyl group includes a saccharide derivative group, and the plurality of $R^1$ s may be the same or different.
R' represents a hydrogen atom, $-OR^1$, an amino group, or $-NR^1_2$.
R" represents a hydrogen atom, $-OR^1$, a carboxyl group, $-COOR^1$, or $-CH_2OR^1$.
$R^5$ represents a hydrogen atom or an alkyl group, where the plurality of $R^5$s may be the same or different.
$X^1$ and $Y^1$ each independently represent a single bond or a linking group, where the plurality of X's may be the same or different, and the plurality of Y's may be the same or different.
P represents an integer of 1 or greater and 3000 or less.

[Chem. 2]

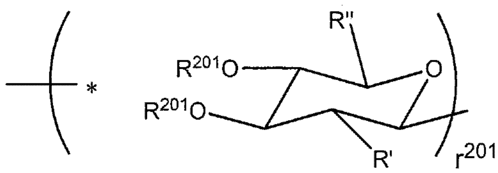

General Formula (2)

In General Formula (2), $R^{201}$ each independently represents a hydrogen atom, a fluorine atom, a chlorine atom, a bromine atom, an iodine atom, an alkyl group, an acyl group, an aryl group, or a phosphoryl group, where the plurality of $R^{201}$s may be the same or different.
R' represents a hydrogen atom, $-OR^1$, an amino group, or $-NR^12$.
R" represents a hydrogen atom, $-OR^1$, a carboxyl group, $-COOR^1$, or $-CH_2OR^1$.
$r^{201}$ represents an integer of 1 or greater.
The mark * represents a bonding site with any one of the oxygen atoms to which $R^{201}$ is bonded, instead of $R^{201}$.

General Formula (1)

First, a structure represented by General Formula (1) will be described as a preferred aspect in which a side chain includes a saccharide derivative moiety.

[Chem. 3]

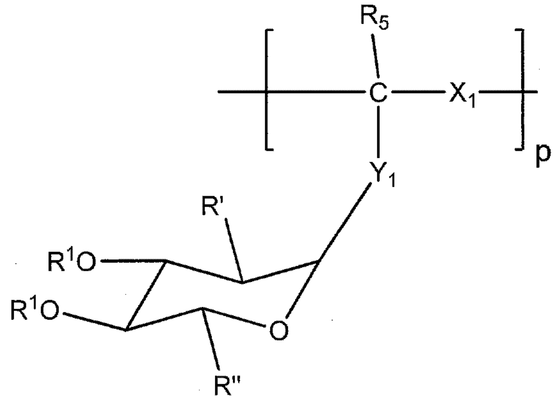

General Formula (1)

In General Formula (1), $R^1$ each independently represents a hydrogen atom, a fluorine atom, a chlorine atom, a bromine atom, an iodine atom, an alkyl group, an acyl group, an aryl group, or a phosphoryl group, where the alkyl group includes a saccharide derivative group, and the plurality of $R^1$s may be the same or different. Among them, $R^1$ is preferably independently a hydrogen atom or an acyl group having 1 or more and 3 or less carbons. Note that because the alkyl group described above includes a saccharide derivative group, the saccharide chain moiety (saccharide derivative moiety) of the polymer moiety (a) may further include a linear or branched saccharide derivative moiety.
The linear or branched saccharide derivative moiety preferably includes a saccharide derivative moiety of the same structure as the saccharide derivative moiety to which the linear or branched saccharide derivative moiety is bonded. That is, when R" in the structure represented by General Formula (1) is a hydrogen atom, $-OR^1$, a carboxyl group, or $-COOR^1$, and the saccharide chain moiety (saccharide derivative moiety) further includes a linear or branched saccharide derivative moiety, the linear or branched saccharide derivative moiety preferably includes a pentose derivative moiety. In addition, when R" in the structure represented by General Formula (1) is $-CH_2OR^1$, and the saccharide chain moiety (saccharide derivative moiety) further includes a linear or branched saccharide derivative moiety, the linear or branched saccharide derivative moiety preferably includes a hexose derivative moiety. An additional substituent that the hydroxyl group of the linear or branched saccharide derivative moiety may include is the same as the range of $R^1$.
In General Formula (1), in terms of reducing the solubility of the copolymer in the organic solvent after the underlayer film is formed by heat treatment, $R^1$ preferably further includes a saccharide derivative moiety as at least one alkyl group, that is, a structure in which a plurality of saccharide derivative moieties derived from a monosaccharide are bonded together is formed. The average degree of polymerization of the saccharide derivative moiety (meaning the number of the bonded saccharide derivative moiety derived from a monosaccharide) is preferably 1 or more and 20 or less, and more preferably 15 or less, and even more preferably 12 or less.
When $R^1$ is an alkyl group or an acyl group, the number of carbons included in the group can be appropriately selected according to the purpose. For example, the alkyl group or the acyl group has preferably 1 or more carbons, preferably 200 or less, more preferably 10 or less, even more preferably 20 or less, and particularly preferably 4 or less carbons.
Specific examples of $R^1$ include an acyl group, such as an acetyl group, a propanoyl group, a butyryl group, an isobutyryl group, a valeryl group, an isovaleryl group, a pivaloyl group, a hexanoyl group, an octanoyl group, a chloroacetyl group, a trifluoroacetyl group, a cyclopentanecarbonyl group, a cyclohexanecarbonyl group, a benzoyl group, a methoxybenzoyl group, and a chlorobenzoyl group; an alkyl group, such as a methyl group, an ethyl group, a propyl group, a butyl group, and t-butyl group. Among them, a methyl group, an ethyl group, an acetyl group, a propanoyl group, a butyryl group, an isobutyryl group, and a benzoyl group are preferred, and an acetyl group and a propanoyl group are particularly preferred.
In General Formula (1), R' represents a hydrogen atom, $-OR^1$, an amino group, or $-NR^1_2$. Preferred structures of R' are-H, -OH, -OAc, $-OCOC_2H_5$, $-OCOC_6H_5$, $-NH_2$, -NHCOOH, and $-NHCOCH_3$; more preferred structures of R' are -H, -OH, -OAc, $-OCOC_2H_5$, and $-NH_2$; and particularly preferred structures of R' are -OH, -OAc, and $-OCOC_2H_5$.
In General Formula (1), R" represents a hydrogen atom, $-OR^1$, a carboxyl group, $-COOR^1$, or - $CH_2OR^1$. Preferred structures of R" are -H, -OAc, $-OCOC_2H_5$, -COOH, $-COOCH_3$, $-COOC_2H_5$, - $CH_2OH$, $-CH_2OAc$, and $-CH_2OCOC_2H_5$; more preferred structures of R" are -H, -OAc, $-OCOC_2H_5$, - COOH, $-CH_2OH$, $-CH_2OAc$, and $-CH_2OCOC_2H_5$; and particularly preferred structures of R" are -H, - $CH_2OH$, and $-CH_2OAc$.
In General Formula (1), $R^5$ represents a hydrogen atom or an alkyl group, where the plurality of $R^5$s may be the same or different. Among them, $R^5$ is preferably a hydrogen atom or an alkyl group having from 1 to 3 carbons and is particularly preferably a hydrogen atom or a methyl group.
In General Formula (1), $X^1$ and $Y^1$ each independently represent a single bond or a linking group, where the

plurality of $X^1$ s may be the same or different, and the plurality of $Y^1$s may be the same or different.
When $X^1$ is a linking group, examples of $X^1$ include an alkylene group; and a group containing -O-, - $NH_2$-, a carbonyl group, or the like; but $X^1$ is preferably a single bond or an alkylene group having 1 or more and 6 or less carbons, and more preferably an alkylene group having 1 or more and 3 or less carbons.
When $Y^1$ is a linking group, examples of $Y^1$ include an alkylene group; phenylene group; and a group containing -O- or -C(=O)O-. $Y^1$ may be a linking group in which these groups are combined. Among them, $Y^1$ is preferably a linking group represented by structural formulas below.

[Chem. 4]

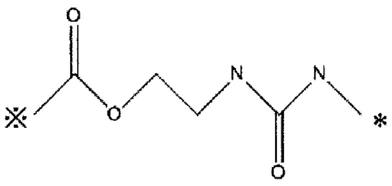
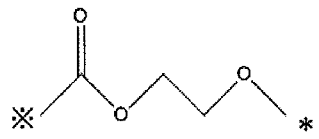
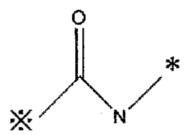
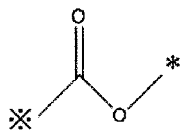
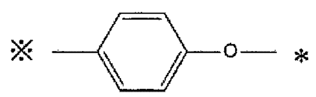

In the above structural formulas, the mark ** represents a bonding site with the main chain side, and the mark * represents a bonding site with a saccharide unit of the side chain.
In General Formula (1), p only needs to be 1 or greater. In addition, p may be 2 or greater, is preferably 3 or greater, more preferably 4 or greater, and even more preferably 5 or greater. Furthermore, p only needs to be 3000 or less, and is preferably 2500 or less and more preferably 2000 or less.
The value of p in General Formula (1) is preferably calculated from the value measured by gel permeation chromatography. Examples of other measurement methods may include size exclusion chromatography, light scattering method, viscometry, end group quantification method, and sedimentation velocity method. The molecular weight is determined from such a measurement value, and the value divided by the molecular weight of the unit structure is p. At this time, the molecular weight of the unit structure can be determined from each of $^1$H-NMR and $^{13}$C-NMR spectra and the average degree of polymerization of the saccharide derivative moiety. Furthermore, in addition to the NMR information, information such as MS spectrum and IR spectrum, is more preferably combined to determine the unit structure.
As can be seen from the structural formula of General Formula (1), the polymer moiety (a) preferably contains a glucose derivative unit or a xylose derivative unit, that is, contains a saccharide derivative unit. In General Formula (1), when p is 2 or greater, a saccharide derivative moiety having a different degree of polymerization may be connected via $Y^1$ in each of p repeating units. That is, the degree of polymerization of the saccharide derivative moiety may be a different value in each of p repeating units as long as the degree of polymerization is within the above range.
Note that, in the present specification, the degree of polymerization of the saccharide derivative moiety is the number of saccharide units forming one saccharide derivative moiety, but when p is 2 or greater, a plurality of saccharide derivative moieties will be contained in the structure represented by General Formula (1). In this case, saccharide derivative moieties having a different degree of polymerization may be contained in the structure represented by General Formula (1), and the average degree of polymerization of the saccharide derivative moiety may not necessarily be an integer. In addition, for the saccharide derivative moiety including a side chain structure, the number of saccharide units constituting the side chain is also included in the average degree of polymerization. The average degree of polymerization of the saccharide derivative moiety described above can be calculated by the following measurement method.
First, the solution containing the polymer moiety (a) is maintained at 50°C and centrifuged at 15000 rpm for 15 minutes, and insoluble matter is removed. The total amount of sugar and the amount of reducing sugar (both in terms of xylose) of the supernatant liquid are then measured. Then, the average degree of polymerization is calculated by dividing the total amount of sugar by the amount of reducing sugar. Note that if the above measurement method cannot be employed, a method, such as gel permeation chromatography, size exclusion chromatography, light scattering method, viscometry, end group quantification method, sedimentation velocity method, MULDI-TOF-MS method, or structural analysis by NMR, may be employed.
In measuring the average degree of polymerization of the saccharide derivative moiety after the copolymer synthesis, the integrated value of the peak derived from the saccharide chain (at or near 3.3 to 5.5 ppm) and the integrated value of peaks derived from other components of the polymer moiety (a) are calculated in $^1$H-NMR, and the average

degree of polymerization is calculated from the ratio of each integrated value. Note that when $R^1$ in General Formula (1) is not a hydrogen atom, the integrated value of the peak derived from an $-OR^1$ group can be used instead of that of the peak derived from the saccharide chain (where $R^1$ of the $-OR^1$ group in this case is not a saccharide chain).

General Formula (2)

Next, a structure represented by General Formula (2) will be described as a preferred aspect in which a main chain includes a saccharide derivative moiety.

[Chem. 5]

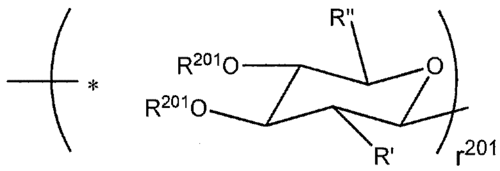

General Formula (2)

In General Formula (2), $R^{201}$ each independently represents a hydrogen atom, a fluorine atom, a chlorine atom, a bromine atom, an iodine atom, an alkyl group, an acyl group, an aryl group, or a phosphoryl group, where the plurality of $R^{201}$s may be the same or different.
R' represents a hydrogen atom, $-OR^1$, an amino group, or $-NR^12$.
R" represents a hydrogen atom, $-OR^1$, a carboxyl group, $-COOR^1$, or $-CH_2OR^1$.
$r^{201}$ represents an integer of 1 or greater.
The mark * represents a bonding site with any one of the oxygen atoms to which $R^{201}$ is bonded, instead of $R^{201}$.
In General Formula (2), preferred ranges of $R^{201}$, R', and R" are similar to the preferred ranges of $R^1$, R', and R" in General Formula (1).
In General Formula (2), $r^{201}$ represents an integer of 1 or greater. Note that $r^{201}$ is the average degree of polymerization of the saccharide derivative moiety (meaning the number of the bonded saccharide derivative moiety derived from a monosaccharide). $r^{201}$ is preferably 2 or greater, more preferably 3 or greater, and even more preferably 5 or greater. In addition, $r^{201}$ is preferably 1500 or less, more preferably 1200 or less, even more preferably 500 or less, still more preferably 100 or less, and particularly preferably 90 or less. Furthermore, $r^{201}$ is preferably an integer of 5 or greater and 80 or less.

Polymer moiety (b)

In an embodiment of the present invention, the polymer moiety (b) includes no saccharide derivative moiety. The polymer moiety (b) has a structure different from that of the polymer moiety (a).
The polymer moiety (b) preferably has a structure different from that of the polymer moiety (a) (for example, hydrophobic compared to the polymer moiety (a)) to increase the solubility of the copolymer, which is the material of the underlayer film-forming composition, in the organic solvent. In addition, the polymer moiety (b) is preferably more hydrophobic than the polymer moiety (a) in terms of easily increasing the coated film residual rate upon forming the underlayer film without unnecessarily affecting the cross-linking properties. However, the relationship between the hydrophobicity of the polymer moiety (b) and the hydrophilicity of the polymer moiety (a) is not particularly limited.
Examples of the unit constituting the polymer moiety (b) may include a styrene-derived unit, a vinyl naphthalene-derived unit, a methyl(meth)acrylate-derived unit, and a lactic acid-derived unit, which may include a substituent. The polymer moiety (b) is preferably a styrene-derived unit or a vinyl naphthalene-derived unit that may include a hydrophobic substituent in terms of increasing the solubility of the copolymer in the organic solvent.

General Formula (105)

In an embodiment of the present invention, the polymer moiety (b) preferably includes a structure represented by General Formula (105) below. In this case, the copolymer can exhibit the effect of preventing diffuse reflection of ultraviolet light during laser exposure and can enhance the anti-reflective effect for ultraviolet light.

[Chem. 6]

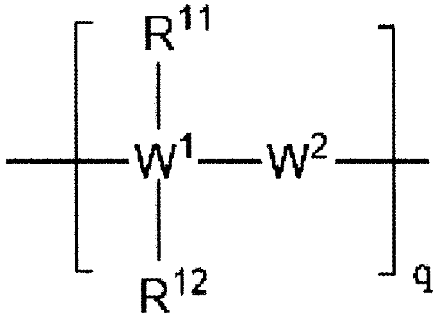

General Formula (105)

In General Formula (105), $W^1$ represents a carbon atom or a silicon atom, where the plurality of $W^1$s may be the same or different;

$W^2$ represents $-CR_2-$, -O-, -COO-, -S-, or $-SiR_2-$ (where R represents a hydrogen atom or an alkyl group having from 1 to 5 carbons, and the plurality of Rs may be the same or different), and the plurality of $W^2$s may be the same or different;

$R^{11}$ represents a hydrogen atom, a methyl group, an ethyl group, or a hydroxyl group, where the plurality of $R^{11}$s may be the same or different;

$R^{12}$ represents a hydrogen atom, a hydroxyl group, an acetyl group, an alkoxy group, a hydroxyalkyloxycarbonyl group, a hydroxyallyloxycarbonyl group, an alkoxycarbonyl group, an aryloxycarbonyl group, an aryl group, or a pyridyl group, where the plurality of $R^{12}$s may be the same or different, and $R^{12}$ may further include a substituent; and

q represents an integer of 1 or greater and 3000 or less.

In General Formula (105), $W^1$ represents a carbon atom or a silicon atom, where the plurality of $W^1$s may be the same or different. Among them, $W^1$ is preferably a carbon atom in terms of being able to form an underlayer film that is not prone to cracking by heat treatment. In addition, in General Formula (105), $W^2$ represents $-CR_2-$, -O-, -COO-, -S-, or $-SiR_2-$ (where R represents a hydrogen atom or an alkyl group having from 1 to 5 carbons, and the plurality of Rs may be the same or different), and the plurality of $W^2$s may be the same or different. Among them, $W^2$ is preferably - $CR^2$- or -COO- in terms of being able to form an underlayer film that is not prone to cracking by heat treatment and more preferably -$CH^2$-.

In General Formula (105), $R^{11}$ represents a hydrogen atom, a methyl group, or a hydroxyl group, where the plurality of $R^{11}$s may be the same or different. $R^{11}$ is more preferably a hydrogen atom or a methyl group and even more preferably a hydrogen atom. In General Formula (105), $R^{12}$ represents a hydrogen atom, a hydroxyl group, an acetyl group, a methoxycarbonyl group, an aryl group, or a pyridyl group, where the plurality of $R^{12}$ may be the same or different. $R^{12}$ is preferably an aryl group or a pyridyl group, more preferably an aryl group, and even more preferably a phenyl group. In addition, the phenyl group is preferably a phenyl group including a substituent. Examples of the phenyl group including a substituent may include a 4-t-butyl phenyl group, a methoxyphenyl group, a dimethoxyphenyl group, a trimethoxyphenyl group, a trimethylsilylphenyl group, and a tetramethyldisilylphenyl group. In addition, $R^{12}$ is preferably a naphthalene group.

As described above, $R^{12}$ is preferably a phenyl group, and the polymer moiety (b) is particularly preferably a styrene-based polymer. The aromatic ring-containing unit other than the styrene-based polymer can be exemplified by those described below. The styrene-based polymer is a polymer obtained by polymerizing a monomer compound containing a styrene compound. Examples of the styrene compound include styrene, o-methyl styrene, p-methyl styrene, ethyl styrene, p-methoxystyrene, p-phenylstyrene, 2,4-dimethylstyrene, p-n-octylstyrene, p-n-decylstyrene, p-n-dodecylstyrene, chlorostyrene, bromostyrene, trimethylsilylstyrene, hydroxystyrene, 3,4,5-methoxystyrene, and pentamethyldisilylstyrene. Among them, the styrene compound is preferably at least one compound selected from styrene and trimethylsilyl styrene, and more preferably styrene. That is, the styrene-based polymer is preferably at least one polymer selected from polystyrene and polytrimethylsilylstyrene, and more preferably polystyrene.

In General Formula (105), q only needs to be 1 or greater. In addition, q may be 2 or greater, preferably 3 or greater, and more preferably 4 or greater. Furthermore, q is 3000 or less, more preferably 2000 or less, and even more preferably 1500 or less. The value of q in General Formula (105) is preferably calculated from the value measured by gel permeation chromatography. Example of other measurement methods may include size exclusion chromatography, light scattering method, viscometry, end group quantification method, and sedimentation velocity method. The molecular weight is determined from such a measurement value, and the value divided by the molecular weight of the unit structure is q. At this time, the molecular weight of the unit structure can be determined from $^1$H-NMR. Furthermore, in addition to the NMR information, information, such as MS spectrum and IR spectrum, is more preferably combined to obtain the

unit structure.

Unit ratio of polymer moiety (a) and polymer moiety (b)

The unit ratio of the polymer moiety (a) and the polymer moiety (b) of the copolymer is preferably from 2:98 to 98:2, more preferably from 3:97 to 97:3, and particularly preferred from 5:95 to 95:5. That is, in General Formulas (113) and (114) of the overall structure of the copolymer to be described later, the unit ratio of the polymer moiety (a) and the polymer moiety (b) is preferably from 2:98 to 98:2, more preferably from 3:97 to 97:3, and particularly preferably from 5:95 to 95:5. Note that the unit ratio is the ratio (molar ratio) of the number of units constituting the polymer moiety (a) and the number of units constituting the polymer moiety (b).

Additional constituent unit

The copolymer may include an additional constituent unit other than the above constituent units. Note that, in some cases, the additional constituent unit may be classified as the polymer moiety (a) or the polymer moiety (b).

Constituent units represented by General Formulas (205) and (206)

The copolymer more preferably contains at least one constituent unit selected from those represented by General Formulas (205) and (206) below as the additional constituent unit.
The constituent unit represented by General Formula (205) is preferably contained in the polymer moiety (a) for the constituent unit including an oxygen atom and is preferably contained in the polymer moiety (b) for the constituent unit including no oxygen atom.
The constituent unit represented by General Formula (206) is hydrophilic and thus is preferably contained in the polymer moiety (a) but may be contained in the polymer moiety (b) when the polymer moiety (b) is not present other than the constituent unit represented by General Formula (206).

[Chem. 7]

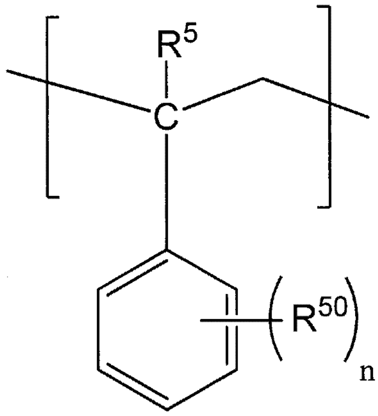

General Formula (205)

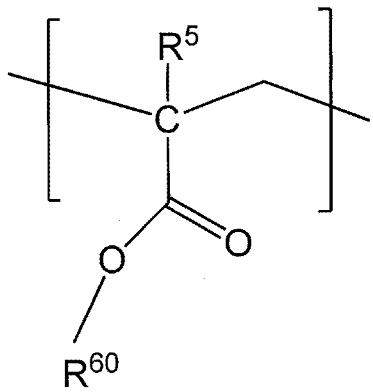

General Formula (206)

A preferred range of $R^5$ in General Formulas (205) and (206) is similar to the preferred range of $R^5$ in General Formula (1).

In General Formula (205), $R^{50}$ represents an organic group or a hydroxyl group. When $R^{50}$ is an organic group, $R^{50}$ is preferably a hydrocarbon group that may include a substituent and is preferably an alkyl group that may include a substituent. Examples of the hydrocarbon group that may include a substituent may also include those in which any of the carbon atoms constituting the hydrocarbon group is substituted with an oxygen atom, a silicon atom, a nitrogen atom, a sulfur atom, or a halogen. For example, $R^{50}$ may be a trimethylsilyl group, a pentamethyldisilyl group, a trifluoromethyl group, or a pentafluoroethyl group. When $R^{50}$ represents a hydroxyl group, the structure represented by General Formula (205) is preferably a constituent unit derived from hydroxystyrene.

In General Formula (205), n represents an integer of 0 to 5, and is preferably an integer from 0 to 3 and particularly preferably 1.

Preferred examples of the structure represented by General Formula (205) may include a structure represented by the following structural formula.

[Chem. 8]

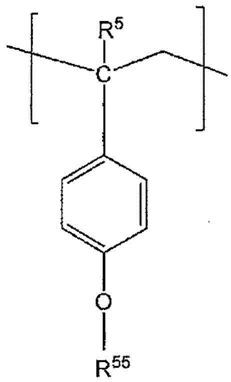

In the above structural formula, $R^5$ represents a hydrogen atom or an alkyl group, and $R^{55}$ is preferably an alkyl group that may include a hydrogen atom or a substituent, and the alkyl group also includes a saccharide constituent unit or a saccharide chain.

In General Formula (206), $R^{60}$ represents an alkyl group. $R^{60}$ is preferably an alkyl group having from 1 to 5 carbons, more preferably an alkyl group having from 1 to 3 carbons, and particularly preferably a methyl group.

In addition, $R^{60}$ may be an alkyl group including a substituent. Examples of the alkyl group including a substituent may include methyl, ethyl, propyl, isopropyl, butyl, isobutyl, t-butyl, $-CH_2$-OH, $-CH_2$-O-methyl, $-CH_2$-O-ethyl, $-CH_2$-O-propyl, $-CH_2$-O-isopropyl, $-CH_2$-O-butyl, $-CH_2$-O-isobutyl, $-CH_2$-O-t-butyl, $-CH_2$-O-(C=O)-methyl, $-CH_2$-O-(C=O)-ethyl, $-CH_2$-O-(C=O)-propyl, $-CH_2$-O-(C=O)-isopropyl, $-CH_2$-O-(C=O)-butyl, $-CH_2$-O-(C=O)-isobutyl, $-CH_2$-O-(C=O)-t-butyl, $-C_2H_4$-OH, $-C_2H_4$-O-methyl, $-C_2H_4$-O-ethyl, $-C_2H_4$-O-propyl, $-C_2H_4$-O-isopropyl, $-C_2H_4$-O-butyl, $-C_2H_4$-O-isobutyl, $-C_2H_4$-O-t-butyl, $-C_2H_4$-O-(C=O)-methyl, $-C_2H_4$-O-(C=O)-ethyl, $-C_2H_4$-O-(C=O)-propyl, $-C_2H_4$-O-(C=O)-isopropyl, $-C_2H_4$-O-(C=O)-butyl, $-C_2H_4$-O-(C=O)-isobutyl, and $-C_2H_4$-O-(C=O)-t-butyl.

Overall structure of copolymer

The copolymer preferably includes a structure represented by General Formula (113) or (114) below. The side chains of the polymer moieties (a) in General Formulas (113) and (114) are each similar to the preferred range of the side chain of the structure represented by General Formula (1).

[Chem. 9]

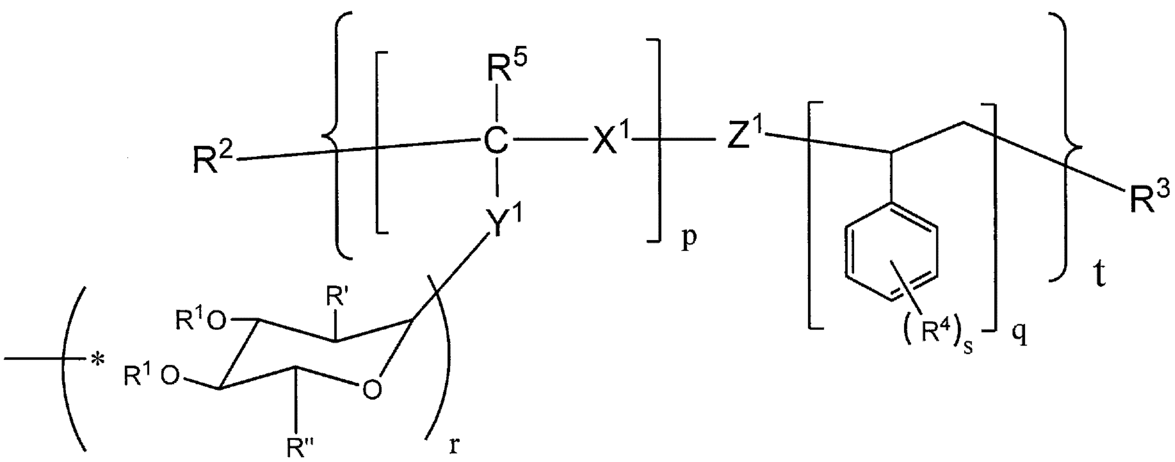

General Formula (113)

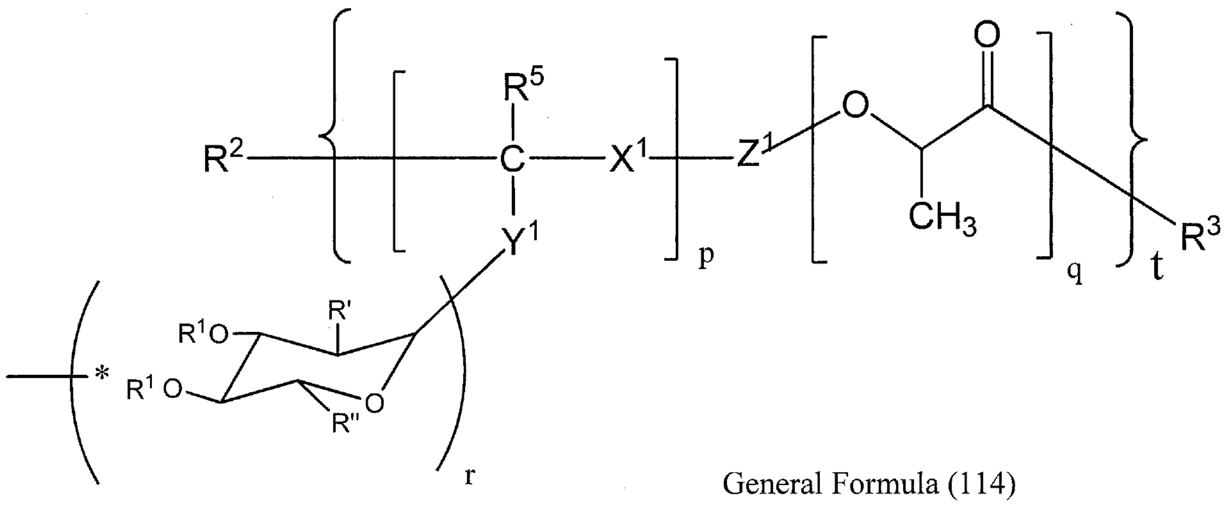

General Formula (114)

In General Formulas (113) and (114), $R^1$ each independently represents a hydrogen atom, a fluorine atom, a chlorine atom, a bromine atom, an iodine atom, an alkyl group, an acyl group, an aryl group, or a phosphoryl group, where the plurality of $R^1$s may be the same or different. $R^2$ represents a hydrogen atom or a substituent, $R^3$ represents a hydrogen atom or a substituent, and $R^4$ represents a halogen atom, a hydroxyl group, an alkyl group, an acyl group, a trimethylsilyl group, or a 1,1,2,2,2-pentamethyldisilyl group, where when s is 2 or greater, the plurality of $R^4$s may be the same or different. $R^5$ represents a hydrogen atom or an alkyl group, where the plurality of $R^5$s may be the same or different. R' represents a hydrogen atom, $-OR^1$, an amino group, or $-NR^1_2$.R" represents a hydrogen atom, $-OR^1$, a carboxyl group, $-COOR^1$, or $-CH_2OR^1$. $X^1$, $Y^1$, and $Z^1$ each independently represent a single bond or a linking group, where the plurality of X's may be the same or different, and the plurality of $Y^1$s may be the same or different. p represents an integer of 1 or greater and 3000 or less; q represents an integer of 1 or greater and 3000 or less; r represents an integer of 0 or greater, where at least one of the plurality of r's represents an integer of 1 or greater; and s represents an integer of 0 or greater and 5 or less. Note that when the copolymer is a block copolymer, t represents an integer of 1 or greater, and p and q each represent an integer of 2 or greater. In addition, when the copolymer is a random copolymer, t represents an integer of 2 or greater, and p and q are each 1. However, the plurality of p's and q's may each be different integers, some may be random copolymers, and some may be block copolymers. The mark * represents a bonding site with any one of $R^1$ or represents a bonding site with any one of the oxygen atoms to which $R^1$ is bonded, instead of $R^1$, when r is 2 or greater.

Preferred ranges of $R^1$, R', and R" in General Formulas (113) and (114) are similar to the preferred ranges of $R^1$, R', and R" in General Formula (1).

In General Formulas (113) and (114), $R^2$ and $R^3$ represent a hydrogen atom or a substituent. $R^2$ and $R^3$ may be the same or different. Examples of the substituent include a fluorine atom; a chlorine atom; a bromine atom; an iodine atom; a hydroxyl group; an amino group; an acyl group, such as an acetyl group, a propanoyl group, a butyryl group, an isobutyryl group, a valeryl group, an isovaleryl group, a pivaloyl group, a hexanoyl group, an octanoyl group, a chloroacetyl group, a trifluoroacetyl group, a cyclopentanecarbonyl group, a cyclohexanecarbonyl group, a benzoyl group, a methoxybenzoyl group, and a chlorobenzoyl group; an alkyl group, such as a methyl group, an ethyl group, a propyl group, an n-butyl group, a sec-butyl group, a tert-butyl group, 2-methylbutyronitrile group, a cyanovalerinoyl group, a cyclohexyl-1-carbonitrile group, a methylpropanoyl group, and an N-butyl-methylpropionamide group; and a substituent represented by a structural formula below. $R^2$ and $R^3$ are each independently preferably a hydrogen atom, a hydroxyl group, an acetyl group, a propanoyl group, a butyryl group, an isobutyryl group, an n-butyl group, a sec-butyl group, a tert-butyl group, 2-methylbutyronitrile, a cyanovalerinoyl group, a cyclohexyl-1-carbonitrile group, a methylpropanoyl group, or a substituent shown below, and particularly preferably a hydrogen atom, a hydroxyl group, a butyl group, or a substituent shown below.

[Chem. 10]

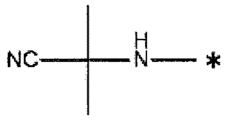 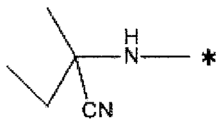 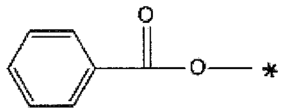 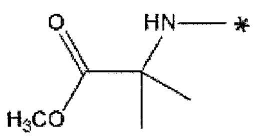

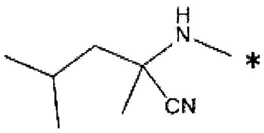 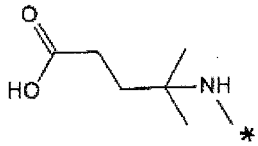 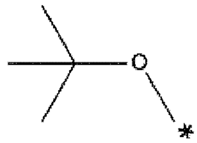 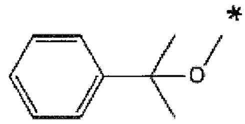

[Chem. 11]

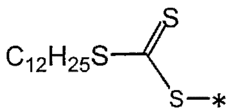 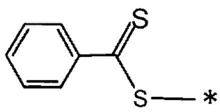 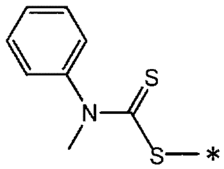 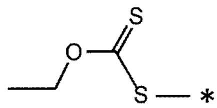

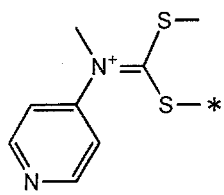 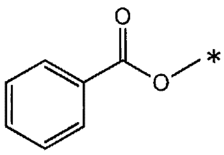 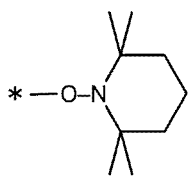 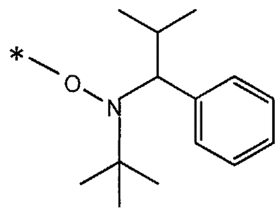

In the above structural formula, the mark * represents a bonding site with the copolymer main chain.

Note that $R^3$ may be a substituent including the structure represented by General Formula (1) described above. That is, the copolymer may be a polymer containing the polymer moiety (a) (the unit (a) derived from a monomer including a saccharide derivative moiety) at both ends of the repeating unit, or may be a polymer including an A-B-A or A-B-A-B-A structure. In addition, $R^2$ may be a substituent including a structure represented by General Formula (105) described above. That is, the copolymer may be a polymer containing two or more polymer moieties (b) or may be a polymer including a B-A-B or B-A-B-A-B structure.
When the copolymer is a random copolymer, the copolymer may be a polymer containing two or more types of polymer moieties (a) or polymer moieties b. In addition, the copolymer may have a structure including partially a random copolymer and partially a block copolymer.

In General Formulas (113) and (114), $R^4$ represents a halogen atom, a hydroxyl group, an alkyl group, an acyl group, a trimethylsilyl group, or a 1,1,2,2,2-pentamethyldisilyl group. s is an integer of 0 to 5, and s is also preferably 0. Note that when s is 2 or greater, the plurality of $R^4$s may be the same or different.

A preferred range of $R^5$ in General Formulas (113) and (114) is similar to the preferred range of $R^5$ in General Formula (1).

In General Formulas (113) and (114), $X^1$, $Y^1$, and $Z^1$ each independently represent a single bond or a linking group, where the plurality of $X^1$s may be the same or different, and the plurality of $Y^1$s may be the same or different.
$X^1$ and $Y^1$ in General Formulas (113) and (114) are respectively independently similar to the preferred ranges of $X^1$ and $Y^1$ in General Formula (1).

When $Z^1$ in General Formulas (113) and (114) is a linking group, examples of the linking group may include -O-, an alkylene group, a disulfide group, and a group represented by the structural formulas below. When $Z^1$ is an alkylene group, a carbon atom in the alkylene group may be substituted with a hetero atom, and examples of the heteroatom include a nitrogen atom, an oxygen atom, a sulfur atom, and a silicon atom. In addition, when $Z^1$ is a linking group, the length of the linking group is preferably shorter than the length of the polymer moiety (a) or the polymer moiety (b).

[Chem. 12]

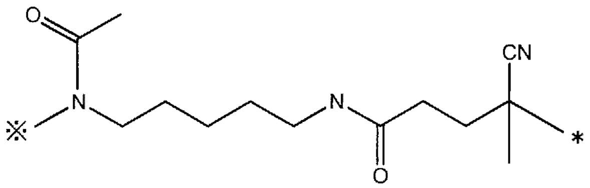

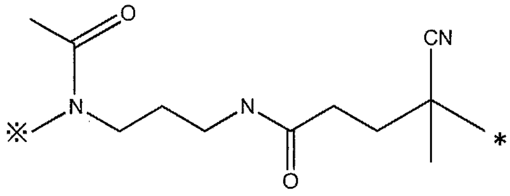

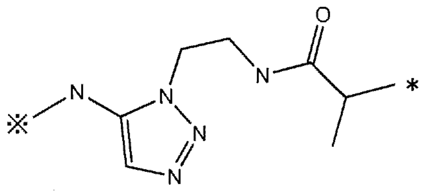

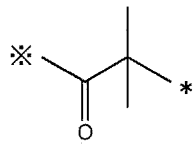

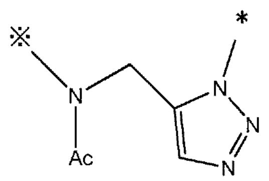

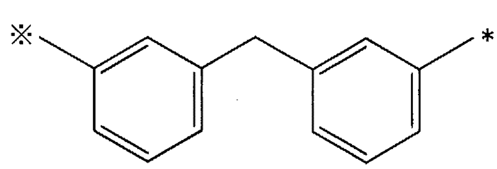

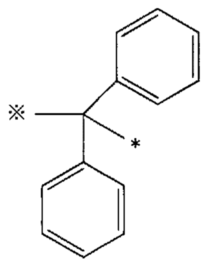

In the above structural formula, the mark * and the mark ** each represent a bonding site with the copolymer main chain, where the mark ** is a bonding site with $X^1$.

In General Formulas (113) and (114), p represents an integer of 1 or greater and 3000 or less, and q represents an integer of 1 or greater and 3000 or less. Preferred ranges of p and q in General Formulas (113) and (114) are respectively similar to the preferred ranges of p and q in General Formulas (1) and (105).

In General Formulas (113) and (114), r represents an integer of 0 or greater, where at least one of the plurality of r's represents an integer of 1 or greater. At least one of r is preferably 1 or greater and 20 or less, more preferably 15 or less, and even more preferably 12 or less.

When the copolymer is a random copolymer, t in General Formulas (113) and (114) is preferably 2 or greater and 5000 or less, more preferably 10 or greater and 4000 or less, and even more preferably 20 or greater and 3000 or less. In addition, when the copolymer is a block copolymer, t in General Formulas (113) and (114) is preferably 1 or greater and 10 or less, more preferably 1 or greater and 5 or less, and even more preferably 1 or greater and 3 or less.

Weight average molecular weight of copolymer

The weight average molecular weight (Mw) of the copolymer is preferably 500 or greater, more preferably 1000 or greater, and even more preferably 1500 or greater. In addition, the weight average molecular weight (Mw) of the copolymer is preferably 1000000 or less, more preferably 500000 or less, even more preferably 300000 or less, and still further preferably 250000 or less. The weight average molecular weight (Mw) of the copolymer is preferably within the above range in terms of solubility and residuality of the coated film after coating. Note that the weight average molecular weight (Mw) of the copolymer is a value measured by GPC in terms of polystyrene.

The ratio (Mw/Mn) of the weight average molecular weight (Mw) and the number average molecular weight (Mn) is preferably 1 or greater. In addition, Mw/Mn is preferably 52 or less, more preferably 10 or less, even more preferably 8 or less, still further preferably 4 or less, and particularly preferably 3 or less. The Mw/Mn is preferably within the above range in terms of solubility and residuality of the coated film after coating.

Solubility of copolymer

The solubility of the copolymer in at least one organic solvent selected from PGMEA, PGME, THF, butyl acetate, anisole, cyclohexanone, ethyl lactate, N-methylpyrrolidone, and DMF is preferably 1 mass% or greater, more preferably 2 mass% or greater, particularly preferably 3 mass% or greater, and more particularly preferably 4 mass% or greater. The upper limit of the solubility of the copolymer in the above organic solvent is not particularly limited but may be, for example, 20 mass%. Note that the above solubility is solubility in at least any organic solvent selected from PGMEA, PGME, THF, butyl acetate, anisole, cyclohexanone, ethyl lactate, N-methylpyrrolidone, and DMF, and the copolymer used in an embodiment of the present invention preferably has a solubility of a certain value or higher in any of the above organic solvents.

The method for measuring the solubility of the copolymer involves gradually adding PGMEA, PGME, THF, butyl acetate, anisole, cyclohexanone, ethyl lactate, N-methylpyrrolidone, or DMF to a predetermined amount of the copolymer while stirring the mixture; and recording the amount of the organic solvent added when the copolymer is dissolved. A magnetic stirrer may be used for stirring. Then, the solubility is calculated from the following formula.

$$\text{Solubility (\%)} = \text{mass of copolymer/amount of organic solvent when copolymer is dissolved} \times 100$$

To dissolve the copolymer in at least any one organic solvent of PGMEA, PGME, THF, butyl acetate, anisole, cyclohexanone, ethyl lactate, N-methylpyrrolidone, and DMF in the above solubility range, for example, the degree of polymerization of the saccharide-derived unit constituting the saccharide derivative moiety in General Formula (1) and/or General Formula (2) can be controlled to a certain value or less. Such a control of the degree of polymerization of the saccharide derivative moiety in General Formula (1) and/or General Formula (2) can more effectively increase the solubility of the copolymer in the organic solvent. In addition, the control of the degree of polymerization of the saccharide-derived unit in General Formula (1) and/or General Formula (2) facilitates the increase in the content of the saccharide derivative moiety, and this can also effectively increase the amount of metal introduction. Furthermore, the control of the degree of polymerization of the saccharide-derived unit can also facilitate the synthesis of the polymer moiety a, and as a result this can also increase the production efficiency of the copolymer.

To control the degree of polymerization of the saccharide derivative moiety within a predetermined range, a method of controlling the degree by controlling the length of the saccharide chain before formed into the copolymer is preferably employed. Specifically, separation and purification using a silica gel column or an ion exchange resin; separation and purification using a reverse osmosis membrane, or ultrafiltration; a method of cutting a saccharide chain using an enzyme; or poor solvent crystallization from an oligosaccharide is performed to control the length of the saccharide chain, and the degree of polymerization of the saccharide derivative moiety can be controlled within a predetermined range. Note that the saccharide chain length can be checked using, for example, a Shodex column KS-801. Additionally, the saccharide chain length can be checked, for example, by MULDI TOF MS, gel permeation chromatography, size exclusion chromatography, light scattering method, viscometry, end group quantification method, or sedimentation velocity method.

Content ratio of saccharide derivative moiety of copolymer

The content ratio of the saccharide derivative moiety in the copolymer is preferably 1 mass% or greater and 95 mass% or less relative to the total mass of the copolymer. The content ratio of the saccharide derivative moiety is preferably 3 mass% or greater and 90 mass% or less, more preferably 7 mass% or greater and 85 mass%,, and particularly preferably 12 mass% or greater and 80 mass%. Here, the saccharide derivative moiety preferably includes a unit represented by General Formula (1) and/or General Formula (2) above.

The content ratio of the saccharide derivative moiety in the copolymer can be calculated by calculating the total mass of the saccharide-derived unit described above contained in the copolymer and dividing the total mass by the gross mass of the copolymer. Specifically, the content of the saccharide derivative moiety in the copolymer can be calculated by the following formula.

$$\text{Content of saccharide derivative moiety (mass\%)} = \text{total mass of saccharide-derived unit/weight average molecular weight of copolymer} \times 100$$

The total mass of the saccharide-derived unit can be determined, for example, from $^{1}$H-NMR and the weight average molecular weight of the copolymer. Specifically, the total mass of the saccharide-derived unit can be calculated

using the following formula.

Total mass of saccharide-derived unit = the degree of polymerization of saccharide-derived unit x molecular weight of saccharide

That is, the content ratio of the saccharide derivative moiety can be calculated using the following formula.

Content ratio (mass%) of saccharide derivative moiety = the degree of polymerization of saccharide-derived unit x molecular weight of saccharide x unit number of the degree of polymerization a/weight average molecular weight of copolymer

Here, the unit number of the degree of polymerization a can be calculated from the weight average molecular weight and the unit ratio of the copolymer, and the molecular weight of each structural unit.

Content of copolymer

The content of the copolymer is preferably 0.1 mass% or greater and 99 mass% or less, and more preferably 0.1 mass% or greater and 50% mass% or less relative to the total mass of the underlayer film-forming composition.

Method for synthesizing copolymer

The copolymer can be synthesized by well-known polymerization methods, such as living radical polymerization, living anionic polymerization, and atom transfer radical polymerization. For example, in living radical polymerization, the copolymer can be obtained by using a polymerization initiator, such as AIBN ($\alpha$,$\alpha$'-azobisisobutyronitrile), and allowing it to react with a monomer. In living anionic polymerization, the copolymer can be obtained by allowing butyl lithium and a monomer to react in the presence of lithium chloride. Note that, in the present example, an example using living anionic polymerization to synthesize the copolymer is described, but the synthesis is not limited to living anionic polymerization, and the copolymer can be appropriately synthesized by each synthesis method described above and well-known synthesis methods.
In addition, a commercially available product may be used as the copolymer or a raw material of the copolymer. Examples of such a product include homopolymers, such as P9128D-SMMAran, P9128C-SMMAran, poly(methyl methacrylate), P9130C-SMMAran, P7040-SMMAran, and P2405-SMMA; and block copolymers; available from Polymer Source Inc. In addition, the copolymer can be appropriately synthesized using these polymers by well-known synthesis methods.

Extraction method of polymer moiety (a)

The polymer moiety (a) may be obtained synthetically, but may be obtained by combining a process of extracting from a woody plant, lignocellulose derived from a herbaceous plant, or the like. In employing a method of extracting from a woody plant, lignocellulose derived from a herbaceous plant, or the like to obtain the saccharide derivative moiety of the polymer moiety a, the extraction method described in JP 2012-100546 A or the like can be used.
Xylan can be extracted, for example, by the method disclosed in JP 2012-180424 A.
Cellulose can be extracted, for example, by the method disclosed in JP 2014-148629 A.

Derivatization of polymer moiety (a)

The polymer moiety (a) is preferably modified for use by acetylation, halogenation, or the like of the OH group of the saccharide moiety using the extraction method described above. For example, in introducing an acetyl group, an acetylated saccharide derivative moiety can be obtained by reaction with acetic anhydride.

Synthesis method of polymer moiety (b)

The polymer moiety (b) may be formed synthetically, or a commercially available product may be used. When

the polymer moiety (b) is polymerized, a well-known synthesis method can be employed. When a commercially available product is used, for example, amino-terminated PS (Mw = 12300 Da, Mw/Mn = 1.02, available from Polymer Source Inc.) or the like can be used.

Coupling reaction

The copolymer can be synthesized with reference to Macromolecules Vol. 36, No. 6, 2003. Specifically, a compound containing the polymer moiety (a) and a compound containing the polymer moiety (b) are added to a solvent containing DMF, water, acetonitrile, and the like, and a reducing agent is added. Examples of the reducing agent may include $NaCNBH_3$. Thereafter, the mixture is stirred at between 30°C and 100°C for from 1 day to 20 days, and a reducing agent is appropriately added as necessary. Water is added to obtain a precipitate, and the copolymer can be obtained by vacuum-drying the solid content.

Other methods for synthesizing the copolymer in addition to the methods described above may include a synthesis method using radical polymerization, RAFT polymerization, ATRP polymerization, click reaction, NMP polymerization, and living anionic polymerization.

Radical polymerization is a polymerization reaction occurred by adding an initiator to generate two free radicals by a thermal reaction or a photoreaction. A polystyrene-polysaccharide methacrylate random copolymer can be synthesized by heating monomers (for example, a styrene monomer and a saccharide methacrylate compound in which methacrylic acid is added to the β-1 position at the terminal of the xylooligosaccharide) and an initiator (for example, an azo compound, such as azobisbutyronitrile (AIBN)) at 150°C.

RAFT Polymerization is a radical initiated polymerization reaction involving an exchange chain reaction using a thiocarbonylthio group. For example, a technique involving converting the OH group attached to the terminal 1 position of the xylooligosaccharide to a thiocarbonylthio group and then allowing a styrene monomer to react at between 30°C and 100°C to synthesize a copolymer (Material Matters vol. 5, No.1, Latest Polymer Synthesis, Sigma-Aldrich Japan Ltd.) can be taken. ATRP polymerization can synthesize a saccharide copolymer (for example, a saccharide-styrene block copolymer) by halogenating the terminal OH group of the saccharide and allowing a metal complex [(such as CuCl, $CuCl_2$, CuBr, $CuBr_2$, or CuI) + TPMA (tris(2-pyridylmethyl)amine)], MeTREN (tris[2-(dimethylamino)ethyl]amine), a monomer (for example, a styrene monomer), and a polymerization initiator (2,2,5-trimethyl-3-(1-phenylethoxy)-4-phenyl-3-azahexane) to react. NMP polymerization involves heating an alkoxyamine derivative as an initiator to cause coupling and reaction with a monomer molecule to form a nitroxide. A radical is then formed by thermal dissociation, and this allows the polymerization reaction to proceed. Such NMP polymerization is one of living radical polymerization reaction. A polystyrene-polysaccharide methacrylate random copolymer can be synthesized by mixing monomers (for example, a styrene monomer and a saccharide methacrylate compound in which methacrylic acid is added to the β-1 position at the terminal of the xylooligosaccharide), using 2,2,6,6-tetramethylpiperidine 1-oxyl (TEMPO) as an initiator, and heating at 140°C.

Living anionic polymerization is a method that performs a polymerization reaction by allowing a polymerization initiator, for example, such as n-BuLi, to react with a monomer. A xylooligosaccharide-styrene block copolymer can be synthesized, for example, by allowing a xylooligosaccharide halogenated at the terminal β-1 position to react with a polymerization initiator and then allowing a styrene monomer to react with the resulting product.

Click reaction is a 1,3-bipolar azide/alkyne cycloaddition reaction using a saccharide including a propargyl group and a Cu catalyst. A linking group including a structure as described below is included between the polymer moiety (a) and the polymer moiety (b).

[Chem. 13]

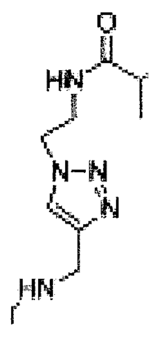

Organic solvent (solvent)

The underlayer film-forming composition contains an organic solvent.
However, in addition to the organic solvent, the underlayer film-forming composition may further contain water or a water-based solvent, such as an aqueous solution. Preferably 95 mass% or greater, more preferably 99 mass% or greater, and particularly preferably 99.9 mass% or greater of the solvent contained in the underlayer film-forming composition is an organic solvent.
Examples of the organic solvent include alcohol-based solvents, ether-based solvents, ketone-based solvents, sulfur-containing solvents, amide-based solvents, ester-based solvents, and hydrocarbon-based solvents. One of these solvents may be used alone, or two or more of these solvents may be used in combination.
Examples of the alcohol-based solvent include methanol, ethanol, n-propanol, i-propanol, n-butanol, i-butanol, sec-butanol, tert-butanol, n-pentanol, i-pentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol, and diacetone alcohol; and ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, 1H,1H-trifluoroethanol, 1H,1H-pentafluoropropanol, and 6-(perfluoroethyl)hexanol.
In addition, examples of a polyhydric alcohol partial ether-based solvent include ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, diethylene glycol dimethyl ether, diethylene glycol ethyl methyl ether, propylene glycol monomethyl ether (PGME), propylene glycol monoethyl ether, propylene glycol monopropyl ether, propylene glycol monobutyl ether, dipropylene glycol monomethyl ether, dipropylene glycol monoethyl ether, and dipropylene glycol monopropyl ether.
Examples of the ether-based solvent include diethyl ether, dipropyl ether, dibutyl ether, diphenyl ether, and tetrahydrofuran (THF).
Examples of the ketone-based solvent include acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclopentanone, cyclohexanone, cycloheptanone, cyclooctanone, methylcyclohexanone, 2,4-pentanedione, acetonylacetone, acetophenone, and furfural.
Examples of the sulfur-containing solvent include dimethyl sulfoxide.
Examples of the amide-based solvent include N,N'-dimethylimidazolidinone, N-methylformamide, N,N-dimethylformamide, N,N-diethylformamide, acetamide, N-methylacetamide, N,N-dimethylacetamide, N-methylpropionamide, and N-methylpyrrolidone.
Examples of the ester-based solvent include diethyl carbonate, propylene carbonate, methyl acetate, ethyl acetate, $\gamma$-butyrolactone, $\gamma$-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether (PGMEA), propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, i-amyl propionate, methyl 3-methoxypropionate, diethyl oxalate, di-n-butyl oxalate, methyl lactate, ethyl lactate, n-butyl lactate, n-amyl lactate, diethyl malonate, dimethyl phthalate, and diethyl phthalate.
Examples of the hydrocarbon-based solvent include aliphatic hydrocarbon-based solvents, such as n-pentane, i-pentane, n-hexane, i-hexane, n-heptane, i-heptane, 2,2,4-trimethylpentane, n-octane, i-octane, cyclohexane, and methylcyclohexane; and aromatic hydrocarbon-based solvents, such as benzene, toluene, xylene, mesitylene, ethylbenzene, trimethylbenzene, methylethylbenzene, n-propylbenzene, i-propylbenzene, diethylbenzene, i-butylbenzene, triethylbenzene, di-i-propylbenzene, n-amylnaphthalene, and anisole.
Among them, the organic solvent is more preferably propylene glycol monomethyl ether acetate (PGMEA), N,N-dimethylformamide (DMF), propylene glycol monomethyl ether (PGME), anisole, ethanol, methanol, acetone, methyl ethyl ketone, hexane, tetrahydrofuran (THF), dimethyl sulfoxide (DMSO), 1H,1H-trifluoroethanol, 1H,1H-pentafluoropropanol, 6-(perfluoroethyl)hexanol, ethyl acetate, propyl acetate, butyl acetate, ethyl lactate, cyclohexanone, $\gamma$-butyrolactone, N-methylpyrrolidone, and furfural, even more preferably PGMEA, PGME, THF, butyl acetate, ethyl lactate, anisole, cyclohexanone, N-methylpyrrolidone or DMF, and still more preferably PGMEA. One of these solvents may be used

alone, or two or more of these solvents may be used in combination.

The content of the organic solvent is preferably 10 mass% or greater, more preferably 20 mass% or greater, and even more preferably 30 mass% or greater relative to the total mass of the underlayer film-forming composition. In addition, the content of the organic solvent is preferably 99.9 mass% or less and more preferably 99 mass% or less. The underlayer film-forming composition containing the organic solvent within the above range can have improved coating properties.

Saccharide derivative

The underlayer film-forming composition may further contain a saccharide derivative other than the copolymer.

In an embodiment of the present invention, the underlayer film-forming composition preferably further contains a saccharide derivative represented by General Formula (3) below.

General Formula (3)

[Chem. 14]

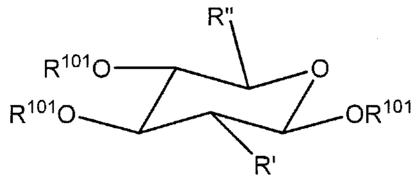

General Formula (3)

In General Formula (3), $R^{101}$ each independently represents a hydrogen atom, a fluorine atom, a chlorine atom, a bromine atom, an iodine atom, an alkyl group, an acyl group, an aryl group, and a phosphoryl group, where the alkyl group contains a saccharide derivative group, with the proviso that $R^{101}$ contains one or more alkyl groups, acyl groups, phenyl groups, or naphthyl groups.

R' represents a hydrogen atom, $-OR^1$, an amino group, or $-NR^1_2$.

R" represents a hydrogen atom, $-OR^1$, a carboxyl group, $-COOR^1$, or $-CH_2OR^1$.

Preferred ranges of $R^{101}$, R', and R" in General Formula (3) are respectively similar to the preferred ranges of $R^1$, R', and R" in General Formula (1).

The saccharide derivative represented by General Formula (3) is preferably a xylose derivative, a xylooligosaccharide derivative, a glucose derivative, a cellulose derivative, and a hemicellulose derivative, and more preferably a xylooligosaccharide derivative and a glucose derivative.

The saccharide chain length of the saccharide derivative is preferably from 1 to 50, more preferably from 1 to 20, particularly preferably from 1 to 15, and more particularly preferably from 1 to 12.

The content of the saccharide derivative is preferably from 1 to 50 mass%, more preferably from 3 to 40 mass%, and particularly preferably from 5 to 30 mass% relative to the total mass of the copolymer.

Cross-linking compound

In an embodiment of the present invention, the underlayer film-forming composition preferably further contains a cross-linking compound in terms of easily causing a cross-linking reaction during heat treatment to form the underlayer film after the underlayer film-forming composition is coated. This cross-linking reaction makes the formed underlayer film robust and decreases the solubility of the underlayer film in organic solvents commonly used in resist-forming compositions (photoresist compositions) or anti-light-reflection film-forming compositions. Examples of the organic solvents include, such as ethylene glycol monomethyl ether, ethyl cellosolve acetate, diethylene glycol monoethyl ether, propylene glycol, propylene glycol monomethyl ether, propylene glycol monomethyl ether acetate, propylene glycol propyl ether acetate, toluene, methyl ethyl ketone, cyclohexanone, ethyl 2-hydroxypropionate, ethyl 2-hydroxy-2-methylpropionate, ethyl ethoxyacetate, methyl pyruvate, ethyl lactate, and butyl lactate. The underlayer film formed from the underlayer film-forming composition according to an embodiment of the present invention is preferably not re-dissolved in the coating solution used to form the resist or the anti-light-reflection film (which serves as the upper layer film of the underlayer film), and the coated film residual rate is preferably high.

The cross-linking compound is not particularly limited, but a cross-linking compound including at least two crosslink-forming substituents is preferably used. A compound including two or more, for example, from 2 to 6 cross-linking substituents of at least one selected from an isocyanate group, an epoxy group, a hydroxymethylamino group,

and an alkoxymethylamino group can be used as the cross-linking compound. Examples of the cross-linking compound include nitrogen-containing compounds including two or more nitrogen atoms, for example, from 2 to 6 nitrogen atoms substituted with a hydroxymethyl group or an alkoxymethyl group. Among them, the cross-linking compound is preferably a nitrogen-containing compound including a nitrogen atom substituted with a group, such as a hydroxymethyl group, a methoxymethyl group, an ethoxymethyl group, a butoxymethyl group, and a hexyloxymethyl group. Specifically, examples of the preferred cross-linking compound include nitrogen-containing compounds, such as hexamethoxymethylmelamine, tetramethoxymethylbenzoguanamine, 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, 1,1,3,3-tetrakis(methoxymethyl)urea, 1,3-bis(hydroxymethyl)-4,5-dihydroxy-2-imidazolinone, and 1,3-bis(methoxymethyl)-4,5-dimethoxy-2-imidazolinone, dicyclohexylcarbodiimide, diisopropylcarbodiimide, di-tert-butylcarbodiimide, and piperazine.
In addition, commercially available cross-linking compounds can be used; such as methoxymethyl type melamine compounds (trade name: Cymel 300, Cymel 301, Cymel 303, and Cymel 350), butoxymethyl type melamine compounds (trade name: Mycoat 506 and Mycoat 508), glycoluril compounds (trade name: Cymel 1170 and Powder Link 1174), a methylated urea resin (trade name: UFR65), butylated urea resins (trade name: UFR300, U-VAN10S60, U-VAN10R, U-VAN11HV) available from Mitsui Cytec Ltd.; and urea/formaldehyde resins (trade name: Beckamine J-300S, Beckamine P-955, and Beckamine N) available from Dainippon Ink Chemical Industries, Ltd. Also, as the cross-linking compound, polymers produced by using an acrylamide compound or a methacrylamide compound substituted with a hydroxymethyl group or an alkoxymethyl group, such as N-hydroxymethyl acrylamide, N-methoxymethyl methacrylamide, N-ethoxymethyl acrylamide, and N-butoxymethyl methacrylamide can be used.
Only one of the cross-linking compound can be used, and two or more of compounds can be also used in combination. These cross-linking compounds can cause a cross-linking reaction by self-condensation. In addition, these cross-linking compounds can cause a cross-linking reaction with the saccharide derivative moiety contained in the copolymer.

The content of the cross-linking compound is preferably from 1 to 50 mass%, more preferably from 1 to 10 mass%, and particularly preferably from 1 to 5 mass% relative to the total mass of the copolymer.

An acid compound, such as p-toluenesulfonic acid, trifluoromethanesulfonic acid, pyridinium-p-toluenesulfonic acid, salicylic acid, sulfosalicylic acid, citric acid, benzoic acid, ammonium dodecylbenzene sulfonate, and hydroxybenzoic acid, can be added to the underlayer film-forming composition as a catalyst to promote a cross-linking reaction. Examples of the acid compound may include aromatic sulfonic acid compounds, such as p-toluenesulfonic acid, pyridinium-p-toluenesulfonic acid, sulfosalicylic acid, 4-chlorobenzenesulfonic acid, 4-hydroxybenzenesulfonic acid, benzenedisulfonic acid, 1-naphthalene sulfonic acid, and pyridinium-1-naphthalene sulfonic acid. In addition, an acid generator such as 2,4,4,6-tetrabromocyclohexadienone, benzointosylate, 2-nitrobenzyltosylate, bis(4-tert-butylphenyl)iodonium trifluoromethanesulfonate, triphenylsulfonium trifluoromethanesulfonate, phenyl-bis(trichloromethyl)-s-triazine, benzointosylate, and N-hydroxysuccinimide trifluoromethanesulfonate, can be added.
An acid compound or an acid generator exemplified above is added in various amounts according to the types and amounts of the copolymer and the cross-linking compound, and the like, but the acid compound or the acid generator is added in an amount of preferably 10 mass% or less, more preferably from 0.02 to 9 mass%, even more preferably from 0.02 to 8 mass%, and particularly preferably from 0.02 to 5 mass% relative to the total mass of the copolymer.

Anti-light-reflection agent

In an embodiment of the present invention, the underlayer film-forming composition preferably further contains an anti-light-reflection agent.
The preferred aspect of the anti-light-reflection agent is the same as the preferred aspect of the material used in the formation of the anti-light-reflection film described below.
The content of the anti-light-reflection agent is preferably from 1 to 50 mass%, more preferably from 1 to 20 mass%, and particularly preferably from 1 to 10 mass% relative to the total mass of the copolymer.

Optional component

The underlayer film-forming composition may further contains an optional component, such as an ionic liquid and a surfactant. The underlayer film-forming composition containing an ionic liquid can increase compatibility between the copolymer and the above organic solvent.
The underlayer film-forming composition containing a surfactant can improve the coating properties of the underlayer film-forming composition to the substrate. In addition, the underlayer film-forming composition containing a surfactant can improve the coating properties of the resist composition or the like to be coated subsequently to the underlayer film-forming composition during pattern formation using the underlayer film-forming composition. Examples of preferred surfactants include nonionic surfactants, fluorochemical surfactants, and silicone-based surfactants.
Additionally, the underlayer film-forming composition may contain any material, such as a known rheology modifier or

an adhesive aid.

## Pattern-forming method

The pattern-forming method includes forming an underlayer film using the underlayer film-forming composition according to an embodiment of the present invention. The formation of the underlayer film using the underlayer film-forming composition is preferably coating the underlayer film-forming composition on the substrate.

The pattern-forming method preferably includes a lithography process in addition to forming the underlayer film using the underlayer film-forming composition according to an embodiment of the present invention. Note that, in an embodiment of the present invention, the pattern-forming method preferably includes introducing a metal into the underlayer film. Furthermore, the lithography process preferably includes forming a resist film on the underlayer film and etching the resist film and the underlayer film.

The pattern-forming method may further include forming an anti-light-reflection film in addition to forming the underlayer film using the underlayer film-forming composition according to an embodiment of the present invention. In particular, when the underlayer film-forming composition contains no anti-light-reflection agent, the pattern-forming method preferably includes forming an anti-light-reflection film. However, when the underlayer film-forming composition contains an anti-light-reflection agent, the pattern-forming method may not include forming an anti-light-reflection film.

Note that the pattern-forming method may further include forming a guide pattern on the substrate between coating the underlayer film-forming composition on the substrate and forming the resist film. In addition, the pattern-forming method may include forming a guide pattern on the substrate before coating the underlayer film-forming composition. Forming a guide pattern is to form a pre-pattern on the underlayer film formed by coating the underlayer film-forming composition.

The pattern-forming method may be applied to a variety of manufacturing methods. For example, the pattern-forming method may be used in a semiconductor manufacturing process. For example, a method for manufacturing a semiconductor preferably includes forming a pattern on a semiconductor substrate by the above pattern-forming method.

## Coating of underlayer film-forming composition on substrate

The pattern-forming method according to an embodiment of the present invention preferably includes coating the underlayer film-forming composition on a substrate. Coating the underlayer film-forming composition on the substrate is to coat the underlayer film-forming composition on the substrate to form an underlayer film.

Examples of the substrate may include substrates made of a material, such as glass, silicon, SiN, GaN, or AlN. In addition, a substrate made of an organic material, such as PET, PE, PEO, PS, cycloolefin polymer, polylactic acid, or cellulose nanofiber, may be used.

The substrate and the underlayer film are preferably layered in this order and the adjacent layers are preferably in direct contact, but an additional layer may be provided between each layer. For example, an anchor layer may be provided between the substrate and the underlayer film. The anchor layer is a layer to control the wettability of the substrate and to enhance adhesion between the substrate and the underlayer film. In addition, a plurality of layers formed of a different material may be sandwiched between the substrate and the underlayer film. These materials may include, but not particularly limited to, inorganic materials, such as $SiO_2$, SiN, $Al_2O_3$, AlN, GaN, GaAs, W, SOC, and SOG; and organic materials, such as commercially available adhesives.

## Coating method

The method for coating the underlayer film-forming composition is not particularly limited, but, for example, the underlayer film-forming composition can be coated on the substrate by a well-known method, such as a spin coating method. In addition, after the underlayer film-forming composition is coated, the underlayer film-forming composition may be cured by light exposure and/or heating to form the underlayer film. Examples of the radiation used for this light exposure include visible light, ultraviolet rays, far ultraviolet rays, X-rays, electron beams, $\gamma$-rays, molecular beams, and ion beams. The temperature at which the coating film is heated is not particularly limited but is preferably 90°C or higher and 550°C or lower. Note that the film thickness of the underlayer film is not particularly limited, but is preferably from 1 nm to 20000 nm, more preferably from 1 nm to 10000 nm, even more preferably from 1 nm to 5000 nm, and particularly preferably from 1 nm to 2000 nm.

The substrate is preferably washed before coated with the underlayer film-forming composition. Washing of the substrate surface improves the coating properties of the underlayer film-forming composition. A typical well-known washing method can be used, and examples of such a washing method include oxygen plasma treatment, ozone oxidation treatment, acid alkali treatment, and chemical modification treatment.

After the formation of the underlayer film, heat treatment (calcination) is preferably performed to form a layer

of the underlayer film from the underlayer film-forming composition. In an embodiment of the present invention, the heat treatment is preferably a heat treatment under the atmosphere and at a relatively low temperature.
The conditions for heat treatment are preferably selected as appropriate from among the heating treatment temperature of 60°C to 350°C and the heating treatment time of 0.3 to 60 minutes. More preferably, the heat treatment temperature is from 130°C to 250°C, and the heat treatment time is from 0.5 to 5 minutes.

After the formation of the underlayer film, the underlayer film may be rinsed using a rinse liquid, such as a solvent, as necessary. The rinsing treatment removes an uncross-linked portion in the underlayer film and thus can enhance film formation properties of the film formed on the underlayer film such as resist.
Note that any rinse liquid capable of dissolving the uncross-linked portion can be used, and examples of such a rinse liquid include solvents, such as propylene glycol monomethyl ether acetate (PGMEA), propylene glycol monomethyl ether (PGME), ethyl lactate (EL), and cyclohexanone; or commercially available thinner liquids.
In addition, after the washing, post-baking may be performed to volatilize the rinse liquid. The temperature conditions of the post-baking are preferably from 80°C to 300°C, and the baking time is preferably from 30 seconds to 600 seconds.

The underlayer film formed from the underlayer film-forming composition according to an embodiment of the present invention may absorb light depending on the wavelength of the light used in the lithography process, and in such a case the underlayer film can function as a layer having an effect of preventing reflected light from the substrate, i.e., an anti-light-reflection film.
When using the underlayer film as an anti-light-reflection film in a lithography process using a KrF excimer laser (wavelength 248 nm), the underlayer film-forming composition preferably contains a component including an anthracene ring or a naphthalene ring. Further, when using the underlayer film as an anti-light-reflection film in a lithography process using an ArF excimer laser (wavelength 193 nm), the underlayer film-forming composition preferably contains a compound including a benzene ring. In addition, when using the underlayer film as an anti-light-reflection film in a lithography process using an F2 excimer laser (wavelength 157 nm), the underlayer film-forming composition preferably contains a compound including a bromine atom or an iodine atom.

Furthermore, the underlayer film can also function as a layer for preventing the interaction between the substrate and a photoresist; a layer for preventing a negative effect of a material used in a photoresist or a substance produced during light exposureto the photoresist on the substrate; a layer for preventing diffusion of a substance produced from the substrate during heating calcination to an upper layer photoresist; a barrier layer for reducing a poisoning effect of a photoresist layer by a semiconductor substrate dielectric layer; or the like.
In addition, the underlayer film formed from the underlayer film-forming composition functions as a planarization material for planarizing the substrate surface.

Formation of anti-light-reflection film

The method of manufacturing a semiconductor may include forming an organic-based or inorganic-based anti-light-reflection film before or after forming the underlayer film on the substrate. In this case, the anti-light-reflection film may be further provided separately from the underlayer film.
An anti-light-reflection film composition used to form the anti-light-reflection film is not particularly limited, and an anti-light-reflection film composition optionally selected from among those commonly used in the lithography process can be used. In addition, the anti-light-reflection film can be formed by commonly used methods, for example, coating with a spinner and a coater, and calcination. Examples of the anti-light-reflection film composition include a composition containing a light-absorbing compound and a polymer as main components; a composition containing a polymer and a cross-linking agent as main components, the polymer including a light-absorbing group linked by a chemical bond; a composition containing a light-absorbing compound and a cross-linking agent as main components; and a composition containing a polymeric cross-linking agent having light-absorbing properties as a main component. These anti-light-reflection film compositions can also contain, as necessary, an acid component, an acid generator component, and a rheology modifier. Any light-absorbing compounds can be used as long as they have a high absorption capacity for light at photosensitive characteristic wavelength region of a photosensitive component in a photoresist provided on the anti-light-reflection film, and examples of such light-absorbing compounds include benzophenone compounds, benzotriazole compounds, azo compounds, naphthalene compounds, anthracene compounds, anthraquinone compounds, and triazine compounds. Examples of the polymer may include polyesters, polyimides, polystyrenes, novolac resins, polyacetals, and acrylic polymers. Examples of the polymer including a light-absorbing group linked by a chemical bond may include polymers including a light-absorbing aromatic ring structure, such as an anthracene ring, a naphthalene ring, a benzene ring, a quinoline ring, a quinoxaline ring, and a thiazole ring.

In addition, the substrate on which the underlayer film-forming composition according to an embodiment of the present invention is to be coated may include an inorganic-based anti-light-reflection film formed by CVD method on the surface, and an underlayer film can be formed on the inorganic-based anti-light-reflection film.

Formation of resist film

The formation of the resist film is preferably a formation of a layer of a photoresist. The method of the formation of the layer of a photoresist is not particularly limited, but a well-known method can be employed. For example, a photoresist composition solution is coated on the underlayer film and calcined, and the layer of a photoresist can be formed.

The photoresist coated and formed on the underlayer film is not particularly limited as long as it is photosensitive to light used for the light exposure. Both a negative photoresist and a positive photoresist can be used. Examples of the photoresist include a positive photoresist formed of a novolac resin and 1,2-naphthoquinone diazide sulfonate ester; a chemically amplified photoresist formed of a binder including a group that degrades with an acid to increase alkaline dissolution rate, and a photoacid generator; a chemically amplified photoresist formed of a low molecular weight compound that degrades with an acid to increase alkaline dissolution rate of the photoresist, an alkali-soluble binder, and a photoacid generator; and a chemically amplified photoresist formed of a binder including a group that degrades with an acid to increase alkaline dissolution rate, a low molecular weight compound that degrades with an acid to increase alkaline dissolution rate of the photoresist, and a photoacid generator. Examples of such a photoresist include trade name APEX-E available from Shipley Company, trade name PAR710 available from Sumitomo Chemical Co., Ltd., and trade name SEPR430 available from Shin-Etsu Chemical Co., Ltd.

The formation of the resist film preferably includes exposing to light through a predetermined mask. For the light exposure, KrF excimer laser (wavelength 248 nm), ArF excimer laser (wavelength 193 nm), and F2 excimer laser (wavelength 157 nm), can be used. After the light exposure, post-exposure bake can be performed as necessary. The post-exposure bake is preferably performed in conditions of a heating temperature of 70°C to 150°C and a heating time of 0.3 to 10 minutes

The formation of the resist film preferably includes developing with a developing solution. The developing removes, for example, a photoresist in a light-exposed portion when a positive photoresist is used to form a pattern of the photoresist. Examples of the developing solution may include an alkaline aqueous solution including an aqueous solution of an alkali metal hydroxide, such as potassium hydroxide and sodium hydroxide; an aqueous solution of a quaternary ammonium hydroxide, such as tetramethylammonium hydroxide, tetraethylammonium hydroxide, and choline; and an aqueous solution of an amine, such as ethanolamine, propylamine, and ethylenediamine. Furthermore, a surfactant can be added to these developing solutions. The developing conditions are appropriately selected from a temperature of 5 to 50°C and a time of 10 to 300 seconds.

Note that, in the formation of the resist film, a self-assembly pattern-forming material can be used instead of a photoresist. In that case, a material, such as PS-PMMA, can be used. When a self-assembly pattern-forming material is used, a self-assembly pattern-forming material layer is formed, and then a heat treatment is preferably performed for phase separation. The heating conditions are appropriately selected from a heating temperature of 100°C to 300°C and a heating time of 0.1 minutes to 60 minutes. In addition, before forming the self-assembly pattern-forming material layer, a base agent may be further formed to enhance phase separation performance. Furthermore, a nanoimprint material can be also used instead of a photoresist. When a nanoimprint material is used, after a nanoimprint material layer is formed, a template in which a reversed pattern of a pattern desired to be formed is engraved in advance is brought into contact with the nanoimprint material layer, and the desired pattern can be formed on the nanoimprint material layer by UV irradiation or heat treatment.

Etching

In the pattern-forming method, the underlayer film is preferably removed and the semiconductor substrate is preferably processed using a pattern of the resist film formed in the formation of the resist film described above as a protective film. Such removal and processing are referred to etching. Examples of the method for removing a portion of the underlayer film in the etching include well-known methods including reactive ion etching (RIE), such as chemical dry etching and chemical wet etching (wet development); and physical etching, such as sputter etching and ion beam etching. The underlayer film is preferably removed by dry etching using a gas, for example, such as tetrafluoromethane, perfluorocyclobutane ($C_4F_8$), perfluoropropane ($C_3F_8$), trifluoromethane, carbon monoxide, argon, oxygen, nitrogen, chlorine, sulfur hexafluoride, difluoromethane, nitrogen trifluoride, and chlorine trifluoride.

In addition, chemical wet etching can be employed in the etching. Examples of the wet etching technique include a method of treating by reaction with acetic acid, a method of treating by reaction with a mixed solution of water and an alcohol, such as ethanol or i-propanol, and a method of irradiating UV light or EB light and then treating with acetic acid or an alcohol.

The pattern can be formed as described above, but the pattern formed is preferably a line-and-space pattern, a hole pattern, or a pillar pattern.

The pattern formed as described above can also be used as a mask, a mold, or a guide. For example, the

pattern formed can be further processed as a mask or a mold on a Si substrate. In addition, the pattern formed is also utilized as a guide for pattern formation using a self-assembly pattern-forming material (directed self-assembly lithography (DSA)).

Introduction of metal

The pattern-forming method preferably further includes introducing a metal into the hydrophilic moiety (saccharide derivative moiety) of the copolymer of the underlayer film, such as SIS method (sequential infiltration synthesis). Examples of the metal to be introduced include Li, Be, Na, Mg, Al, Si, K, Ca, Sc, Ti, V, Cr, Mn, Fe, Co, Ni, Cu, Zn, Ga, Ge, As, Rb, Sr, Y, Zr, Nb, Mo, Ru, Pd, Ag, Cd, In, Sn, Sb, Te, Cs, Ba, La, Hf, Ta, W, Re, Os, Ir, Pt, Au, Hg, Tl, Pb, Bi, Po, Ce, Pr, Nd, Pm, Sm, Eu, Gd, Tb, Dy, Ho, Er, Tm, Yb, and Lu. Such a process can be performed, for example, by the method described in Jornal of Photopolymer Science and Technology, Volume 29, Number 5 (2016) 653-657. In addition, in the introduction of a metal, a method using a metal complex gas or a method of coating a solution containing a metal can be employed.

Introducing a metal is preferably performed after forming the underlayer film. For example, the pattern-forming method preferably includes forming the underlayer film, then forming the resist film, etching, and introducing a metal into the underlayer film, in this order.

Examples

Hereinafter, the characteristics of the present invention will be described more specifically with reference to examples and comparative examples. The materials, used amounts, proportions, processing contents, and processing procedures, described in the examples below can be appropriately changed as long as the change does not depart from the spirit of the present invention. Accordingly, the scope of the present invention should not be construed as limited by the specific examples described below.
Note that, p, q, l, m, and k in the examples of the block copolymer indicate the number of coupling of each polymer moiety, while p, q, l, m, n, and k in the examples of the random copolymer indicate the number of the constituent unit contained in the copolymer.

Preparation of saccharide

A xylooligosaccharide and xylose were obtained by extracting from wood pulp with reference to JP 2012-100546 A.
D-(+)glucose available from Wako Pure Chemical Industries, Ltd. was used.

Synthesis of copolymer

Synthesis of Copolymer 1

Synthesis of Acetyl Saccharide Methacrylate 1

To a mixed solution of 120 g of acetic anhydride and 160 g of acetic acid, 10 g of xylose was added, and the mixture was stirred at 30°C for 2 hours. Approximately 5 times the amount of cold water as that of the solution was slowly added to the solution while the solution was stirred, and the mixture was stirred for 2 hours and then allowed to stand for one night. To a solution prepared by adding 0.6 g of ethylene diamine and 0.7 g of acetic acid to 200 mL of THF in a flask and adjusted to 0°C, 10 g of a precipitated crystal was added, and the mixture was stirred for 4 hours. The mixture was poured into 500 mL of cold water and extracted twice with dichloromethane. In a flask, 10 g of the extract, 150 mL of dichloromethane, and 2.4 g of triethylamine were placed and cooled to -30°C. Then 1.4 g of methacryloyl chloride was added, and the mixture was stirred for 2 hours. The mixture was poured into 150 mL of cold water and extracted twice with dichloromethane. The solvent was concentrated, and 8.1 g of Acetyl Saccharide Methacrylate 1 was obtained. The structure of the resulting Acetyl Saccharide Methacrylate 1 is as follows.

[Chem. 15]

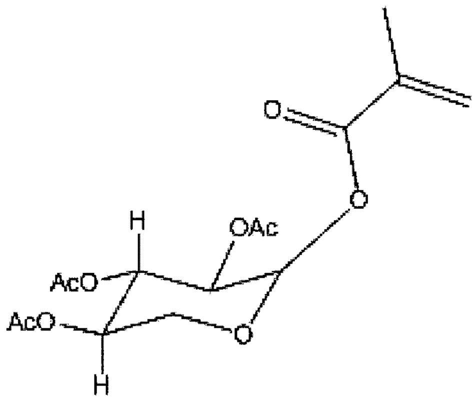

Synthesis of PS-Acetyl Saccharide Methacrylate 1 random copolymer

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Then 30 g of styrene and 270 g of Acetyl Saccharide Methacrylate 1 were added, and the mixture was stirred for 30 minutes. Then 7 g of methanol was added to stop the reaction, and Copolymer 1 was obtained. The structures of the constituent units (a) and (b) of the copolymer contained in the resulting Copolymer 1 are as follows.

[Chem. 16]

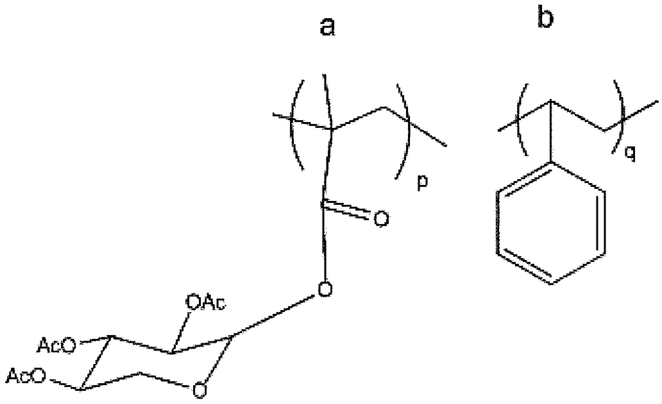

$p = 140$ and $q = 16$

Synthesis of Copolymer 2

Synthesis of Acetyl Saccharide Methacrylate 2

Acetyl Saccharide Methacrylate 2 was synthesized in the same manner as in the synthesis of Acetyl Saccharide Methacrylate 1, with the exception that a xylooligosaccharide having an average degree of polymerization of 3 was used in place of xylose in the synthesis of Acetyl Saccharide Methacrylate 1.

Synthesis of PS-Acetyl Saccharide Methacrylate 2 random copolymer

To a flask, 500 mL of tetrahydrofuran and 92 g of a 2.6 mass% lithium chloride solution in THF (available from

Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed.

Then 30 g of styrene, 50 g of Acetyl Saccharide Methacrylate 2, and 30 g of methyl methacrylate were added, and the mixture was stirred for 30 minutes. Thereafter, 7 g of methanol was added to stop the reaction, and Copolymer 2 was obtained. The structures of the constituent units (a1), (a2), and (b) of the copolymer contained in the resulting Copolymer 2 are as follows.

[Chem. 17]

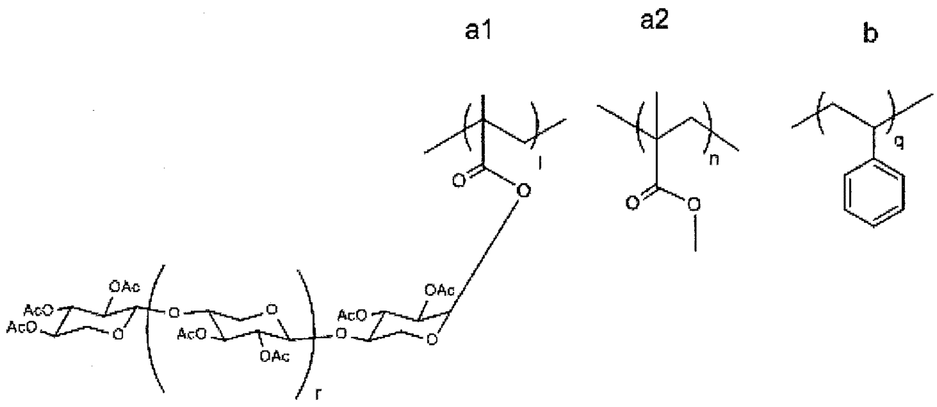

q = 12, n = 55, l = 55, and r = 1

Synthesis of Copolymer 3

Synthesis of Acetyl Saccharide Methacrylate 3

Acetyl Saccharide Methacrylate 3 was synthesized in the same manner as in the synthesis of Acetyl Saccharide Methacrylate 1, with the exception that a xylooligosaccharide having an average degree of polymerization of 5 was used in place of xylose in the synthesis of Acetyl Saccharide Methacrylate 1.

Synthesis of methyl methacrylate-Acetyl Saccharide Methacrylate 3 random copolymer

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed.

Then 300 g of Acetyl Saccharide Methacrylate 3 and 30 g of methyl methacrylate were added, and the mixture was stirred for 30 minutes. Thereafter, 10 g of methanol was added to stop the reaction, and Copolymer 3 was obtained. The structures of the constituent units (a) and (b) of the copolymer contained in the resulting Copolymer 3 are as follows.

[Chem. 18]

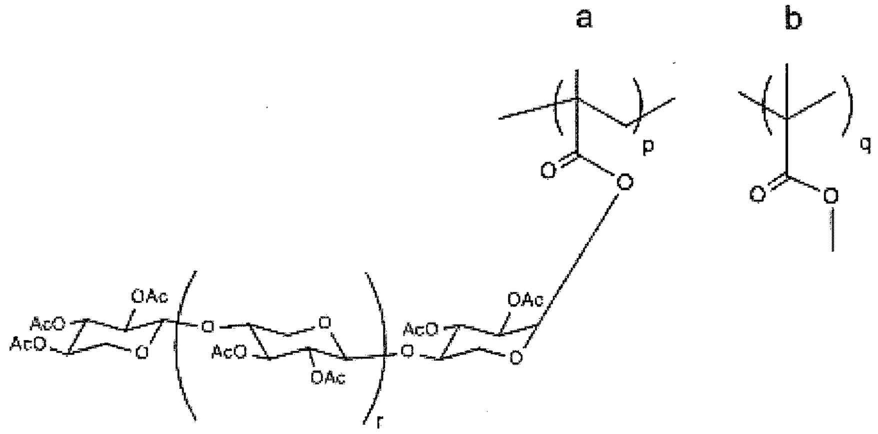

p = 24, q = 213, and r = 3

Synthesis of Copolymer 4

Synthesis of Acetyl Saccharide Methacrylate 4

Acetyl Saccharide Methacrylate 4 was synthesized in the same manner as in the synthesis of Acetyl Saccharide Methacrylate 1, with the exception that a xylooligosaccharide having an average degree of polymerization of 4 was used in place of xylose in the synthesis of Acetyl Saccharide Methacrylate 1.

Synthesis of polyvinyl naphthalene-Acetyl Saccharide Methacrylate 4 random copolymer

To a flask, 1000 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed.
Then 48 g of 1-vinylnaphthalene (available from Tokyo Chemical Industry Co., Ltd.), and a mixture of 90 g of Acetyl Saccharide Methacrylate 4 and 25 g of methyl methacrylate (available from Wako Pure Chemical Industries, Ltd.) was added, and the mixture was stirred for 30 minutes. Thereafter, 14 g of methanol was added to stop the reaction. The resulting random copolymer was washed, filtered, and concentrated, and Copolymer 4 was obtained. The structures of the constituent units (a) and (b) of the copolymer contained in the resulting Copolymer 4 are as follows.

[Chem. 19]

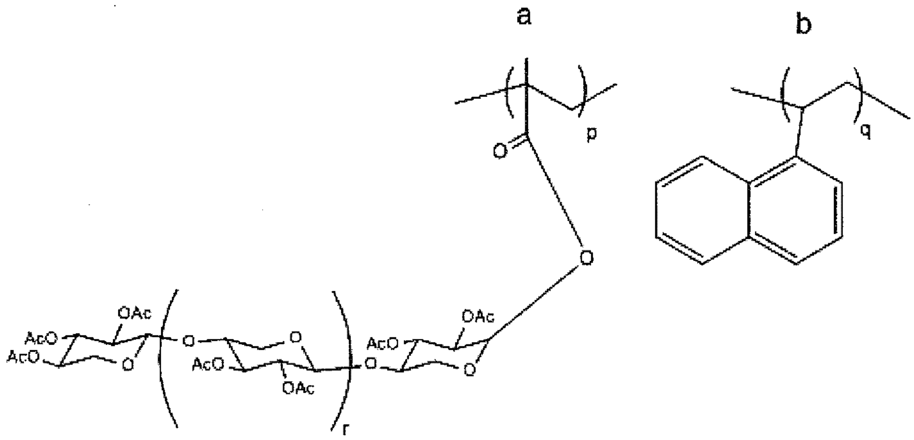

p = 37, q = 86, and r = 2

Synthesis of Copolymer 5

Synthesis of acetyl saccharide styrene

An acetyl saccharide was synthesized in the same manner as in the synthesis of Acetyl Saccharide Methacrylate 1, with the exception that a xylooligosaccharide having an average degree of polymerization of 3 was used in place of xylose in the synthesis of Acetyl Saccharide Methacrylate 1. Then, 10.8 g (90 mmol) of 4-vinylphenol, 32.2 g (32 mmol) of the acetyl saccharide, and 0.5 g of zinc chloride were heated for 30 minutes while being stirred in a silicon oil bath at 160°C. The melt mixture was cooled to about 60°C and dissolved in 200 mL of benzene. The solution was washed twice with water, then with 1 M sodium hydroxide until the aqueous phase became almost colorless, then washed twice with water, then dried and concentrated under reduced pressure, and 26.5 g of an acetyl saccharide styrene was obtained.

Synthesis of PS-acetyl saccharide styrene random copolymer

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Then a mixture of 300 g of the acetyl saccharide styrene and 500 g of polystyrene was added, and the mixture was stirred for 30 minutes. Thereafter, 10 g of methanol was added to stop the reaction, and Copolymer 5 was obtained. The structures of the constituent units (a) and (b) of the copolymer contained in the resulting Copolymer 5 are as follows.

[Chem. 20]

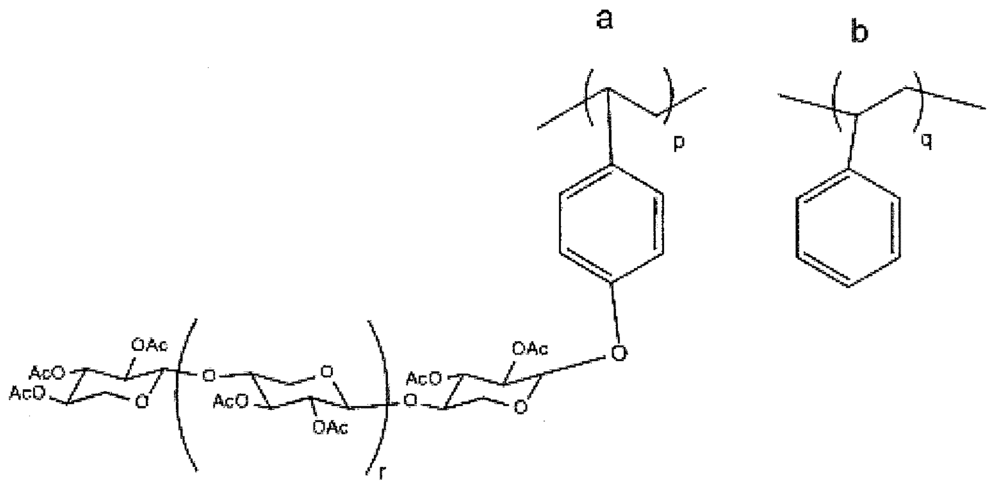

p = 55, q = 55, and r = 1

Synthesis of Copolymer 6

Synthesis of Acetyl Saccharide Methacrylate 5

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Then 300 g of Acetyl Saccharide Methacrylate 1 was added, and the mixture was stirred for 30 minutes. Thereafter, 10 g of methanol was added to stop the reaction, and Acetyl Saccharide Methacrylate 5 was obtained.

Synthesis of polylactic acid

To a flask, 9 g of L-lactic acid was added and degassed, and then 40 mL of dehydrated toluene (available from Wako Pure Chemical Industries, Ltd.) and 0.07 mL of tin (II) 2-ethylhexanoate (available from Sigma-Aldrich Co., Ltd.) was added, and the mixture was stirred at 90°C for 24 hours. After the reaction, the mixture was cooled to room temperature, and 500 mL of methanol was added to stop the reaction, and polylactic acid was obtained.

Synthesis of polylactate-Acetyl Saccharide Methacrylate 5 block copolymer

The block copolymer was synthesized with reference to Macromolecules, Vol. 36, No. 6, 2003. First, 5 g of an acetyl saccharide methacrylate polymer and 5 g of polylactic acid were placed in 100 mL of DMF, and 100 mg of NaCNBH3 was added as a reducing agent. The mixture was stirred at 60°C for 7 days, during which 100 mg of $NaCNBH_3$ was further added every day. The mixture was then cooled to room temperature, and 500 mL of water was added for precipitation. The precipitate was filtered and washed with cold water several times, and excess of the acetyl saccharide was removed. The filtered solid was then vacuum-dried, and Copolymer 6 was obtained. The structure of the copolymer contained in the resulting Copolymer 6 is as follows.

[Chem. 21]

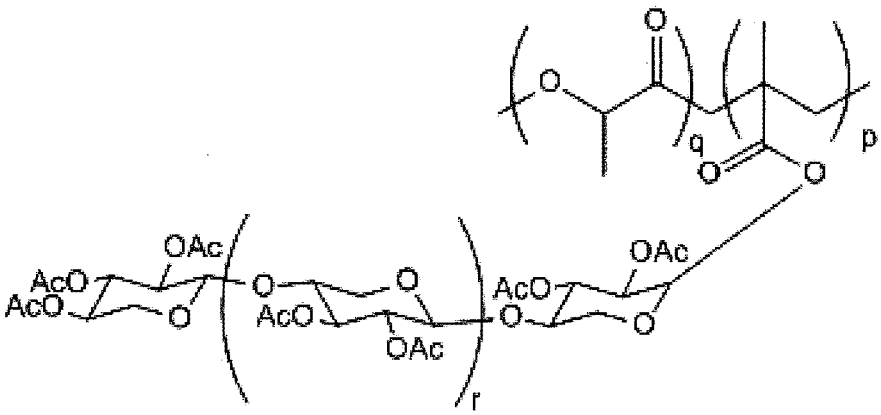

p = 104 and q = 156

Synthesis of Copolymer 7

Synthesis of PS-Acetyl Saccharide Methacrylate 1 block copolymer

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Next, 18.8 g of styrene (available from Wako Pure Chemical Industries, Ltd.) was added, and the mixture was stirred for 15 minutes. Then 1 g of diphenylethylene (available from Wako Pure Chemical Industries, Ltd.) was further added, and the mixture was stirred for 5 minutes. Then 188 g of Acetyl Saccharide Methacrylate 1 was added, and the mixture was further stirred for 15 minutes. Thereafter, 7 g of methanol was added to stop the reaction. The resulting block copolymer was washed, filtered, and concentrated, to obtain Copolymer 7. The structure of the copolymer contained in the resulting Copolymer 7 is as follows.

[Chem. 22]

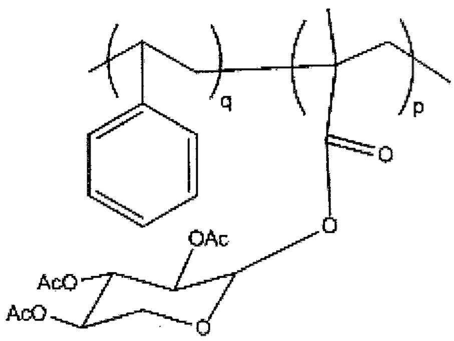

p = 19 and q = 353

Synthesis of Copolymer 8

Synthesis of PS-Acetyl Saccharide Methacrylate 2-ran-methyl methacrylate block copolymer To a flask, 1000 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Next, 48 g of styrene (available from Wako Pure Chemical Industries, Ltd.) was added, and the mixture was stirred for 1 hour. Then 1 g of diphenylethylene was further added,

and the mixture was stirred for 5 minutes. Then a mixture of 90 g of Acetyl Saccharide Methacrylate 2 and 25 g of methyl methacrylate (available from Wako Pure Chemical Industries, Ltd.) was added, and the mixture was further stirred for 30 minutes. Thereafter, 14 g of methanol was added to stop the reaction. The resulting block copolymer was washed, filtered, and concentrated, to obtain Copolymer 8. The structures of the constituent units (a1), (a2), and (b) of the copolymer contained in the resulting Copolymer 8 are as follows.

[Chem. 23]

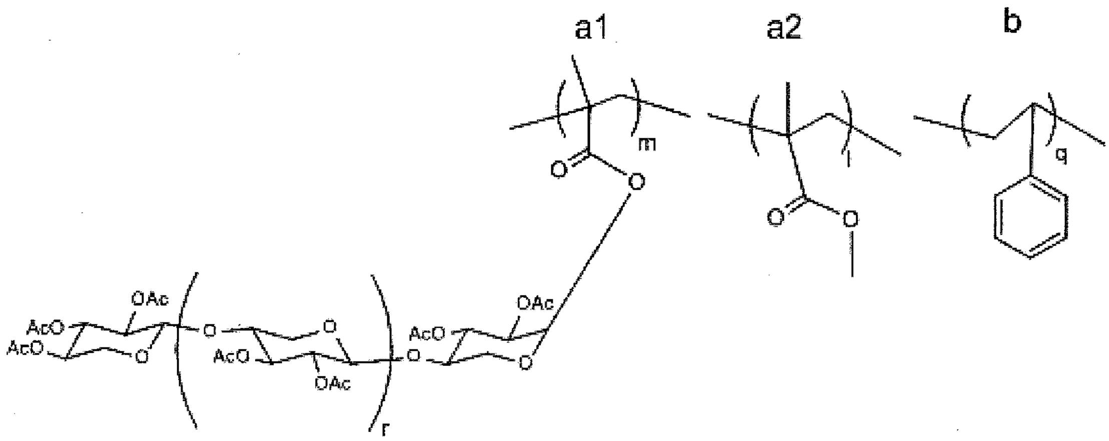

l = 280, m = 120, q = 278, and r = 3

Synthesis of Copolymer 9

Synthesis of Acetyl Saccharide Methacrylate 6

Acetyl Saccharide Methacrylate 6 was synthesized in the same manner as in the synthesis of Acetyl Saccharide Methacrylate 1, with the exception that xylose was changed to D-(+)glucose in the synthesis of Acetyl Saccharide Methacrylate 1.

Synthesis of PS-Acetyl Saccharide Methacrylate 6 block copolymer

To a flask, 1000 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Next, 48 g of styrene (available from Wako Pure Chemical Industries, Ltd.) was added, and the mixture was stirred for 1 hour. Then 1 g of diphenylethylene was further added, and the mixture was stirred for 5 minutes. Then a mixture of 90 g of Acetyl Saccharide Methacrylate 6 and 25 g of methyl methacrylate (available from Wako Pure Chemical Industries, Ltd.) was added, and the mixture was further stirred for 30 minutes. Thereafter, 14 g of methanol was added to stop the reaction. The resulting block copolymer was washed, filtered, and concentrated, to obtain Copolymer 9. The structures of the constituent units (a1), (a2), and (b) of the copolymer contained in the resulting Copolymer 9 are as follows.

[Chem. 24]

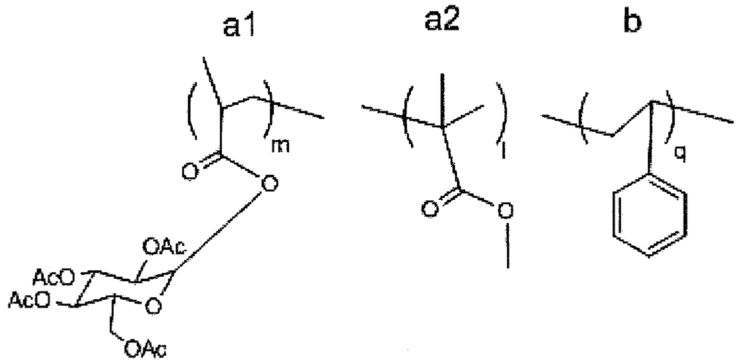

l = 29, m = 29, and q = 234

Synthesis of Copolymer 10

Synthesis of acetyl saccharide acrylate

An acetyl saccharide acrylate (1.0 g) was synthesized in the same manner as in the synthesis of Acetyl Saccharide Methacrylate 2 with the exception that 1.4 g of methacryloyl chloride was replaced with 1.3 g of acryloyl chloride (available from Tokyo Chemical Industry Co., Ltd.) in the synthesis of Acetyl Saccharide Methacrylate 2.

[Chem. 25]

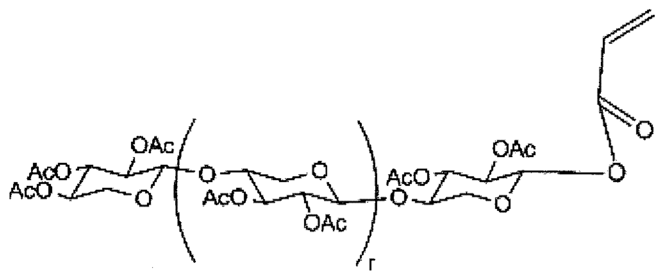

Synthesis of PS-acetyl saccharide acrylate random copolymer

A PS-acetyl saccharide acrylate random copolymer was synthesized in the same manner as in the synthesis of Copolymer 1 with the exception that 270 g of the acetyl saccharide methacrylate was replaced with 232 g of the acetyl saccharide acrylate having an average degree of polymerization of saccharide of 1 in the synthesis of the PS-Acetyl Saccharide Methacrylate 1 random copolymer. The structures of the constituent units (a) and (b) are as follows.

[Chem. 26]

a

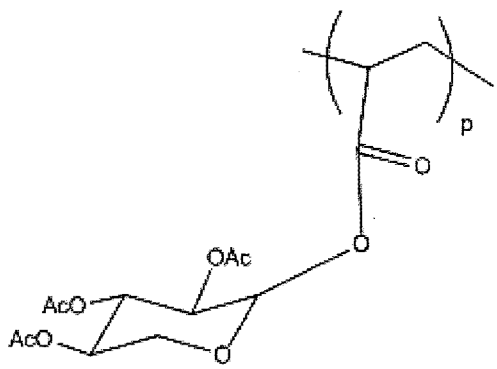

b

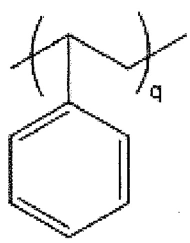

p = 146 and q = 16

Synthesis of Copolymer 11

Synthesis of PS-acetyl saccharide acrylate-ran-methyl acrylate random copolymer A PS-acetyl saccharide acrylate-ran-methyl acrylate random copolymer was synthesized in the same manner as in the synthesis of Copolymer 8 with the exception that 50 g of Acetyl Saccharide Methacrylate 2 was replaced with 40 g of the acetyl saccharide acrylate, and 30 g of methyl methacrylate was replaced with 22 g of methyl acrylate in the synthesis of the PS-Acetyl Saccharide Methacrylate 2-ran-methyl methacrylate random copolymer. The structures of the constituent units (a1), (a2), and (b) are as follows.

[Chem. 27]

a1

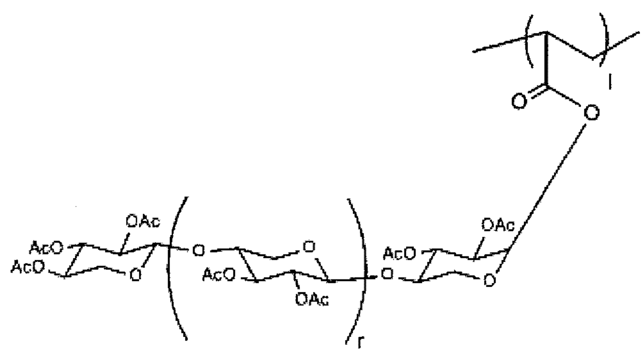

a2

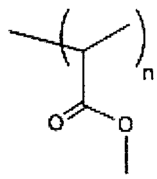

b

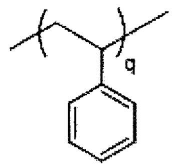

q = 13, l = 57, n = 57, and r = 1

Synthesis of Copolymer 12

Synthesis of PS-acetyl saccharide acrylate-ran-methacrylate random copolymer

A PS-acetyl saccharide acrylate-methacrylate random copolymer was synthesized in the same manner as in the synthesis of Copolymer 11 with the exception that 30 g of methyl methacrylate was replaced with 26 g of methacrylic acid (available from Tokyo Chemical Industry Co., Ltd.) in the PS-acetyl saccharide acrylate-methyl acrylate random copolymer. The structures of the constituent units (a1), (a2), and (b) are as follows.

[Chem. 28]

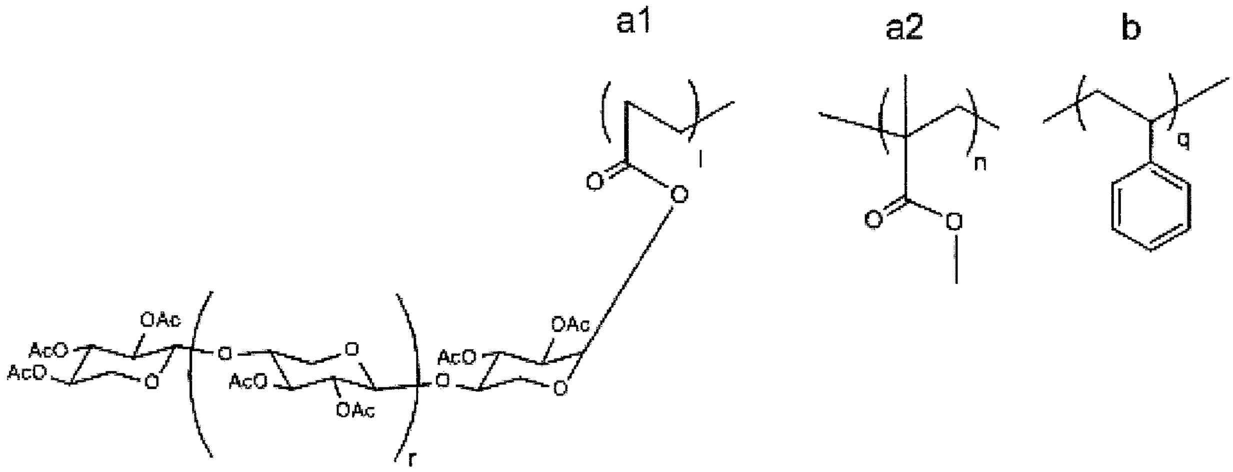

q = 46, n = 54, l = 54, and r = 1

Synthesis of Copolymer 13

Synthesis of PS-acetyl saccharide acrylate-ran-acrylate random copolymer

A PS-acetyl saccharide acrylate-acrylate random copolymer was synthesized in the same manner as in the synthesis of Copolymer 12 with the exception that 26 g of methacrylic acid was replaced with 15 g of acrylic acid (available from Wako Pure Chemical Industries, Ltd.) in the synthesis of the PS-acetyl saccharide acrylate-methacrylate random copolymer. The structures of the constituent units (a1), (a2), and (b) are as follows.

[Chem. 29]

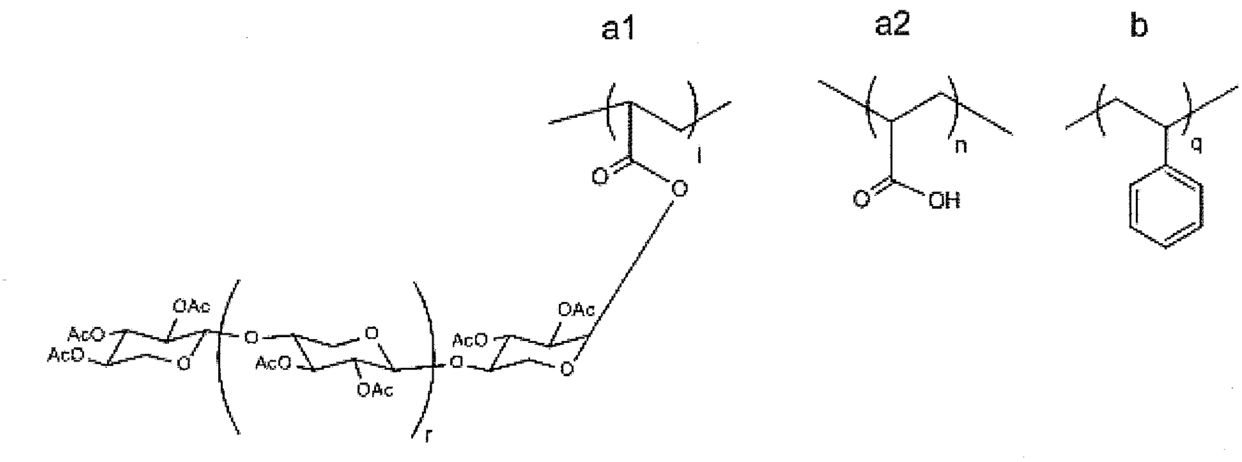

q = 13, n = 57, l = 57, and r = 1

Synthesis of Copolymer 14

Synthesis of PS-acetyl saccharide acrylate-ran-methacrylate chloride random copolymer A PS-acetyl saccharide acrylate-ran-methacrylate chloride random copolymer was synthesized in the same manner as in the synthesis of the PS-Acetyl Saccharide Methacrylate 2-methyl methacrylate random copolymer with the exception that 30 g of methyl methacrylate was replaced with 35 g of methacrylate chloride (available from Tokyo Chemical Industry Co., Ltd.). The structures of the constituent units (a1), (a2), and (b) are as follows.

[Chem. 30]

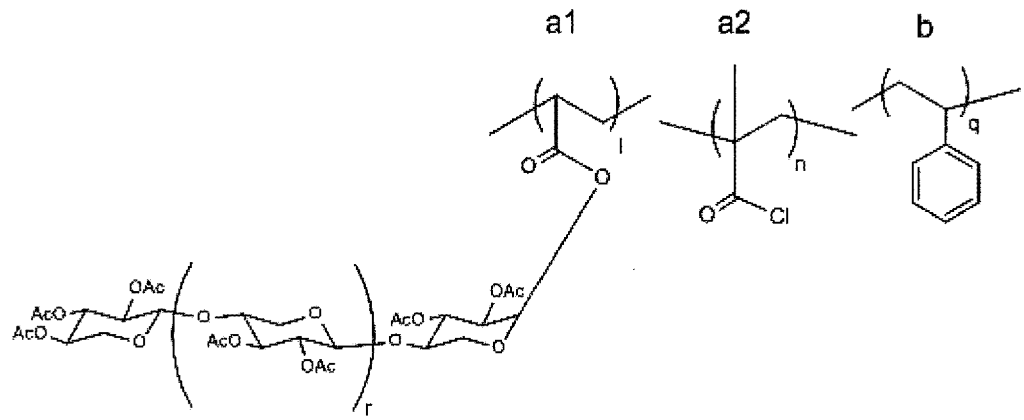

q = 30, n = 10, l = 60, and r = 1

Synthesis of Copolymer 15

Synthesis of acetyl saccharide ethyl methacrylate

An acetyl saccharide ethyl methacrylate (1.1 g) was synthesized in the same manner as in the synthesis of Acetyl Saccharide Methacrylate 2 with the exception that 1.4 g of methacryloyl chloride was replaced with 1.8 g of 1-chloroethyl methacrylate (available from Alfa Aeser) in the synthesis of Acetyl Saccharide Methacrylate 1.

[Chem. 31]

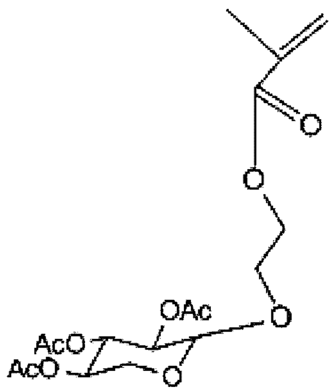

Synthesis of PS-acetyl saccharide ethyl methacrylate-ran-hydroxyethyl methacrylate random copolymer

A PS-acetyl saccharide ethyl methacrylate-ran-hydroxyethyl methacrylate random copolymer was synthesized in the same manner as in the synthesis of Copolymer 8 with the exception that 50 g of Acetyl Saccharide Methacrylate 2 was replaced with 55 g of the acetyl saccharide ethyl methacrylate, and 30 g of methyl methacrylate was replaced with 35 g of hydroxy ethyl methacrylate (available from Tokyo Chemical Industry Co., Ltd.) in the synthesis of the PS-Acetyl Saccharide Methacrylate 2-methyl methacrylate random copolymer. The structures of the constituent units (a1), (a2), and (b) are as follows.

[Chem. 32]

a1 a2 b

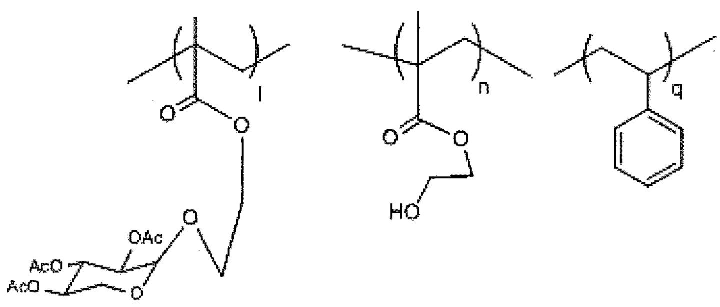

q = 145, n = 72, and l = 72

Synthesis of Copolymer 16

Synthesis of PS-Acetyl Saccharide Methacrylate 2-ran-methyl methacrylate-ran-methacrylate random copolymer

To a flask, 1000 mL of tetrahydrofuran and 92 g of a 2.6 mass% lithium chloride solution in THF were added, and the mixture was cooled to -78°C under an argon atmosphere. Then 13 g of a 15.4 mass% n-butyl lithium solution in hexane was added, and the mixture was stirred for 5 minutes and then dehydrated and degassed. Then 30 g of styrene and a mixture of 90 g of Acetyl Saccharide Methacrylate 2, 25 g of methyl methacrylate, and 5 g of methacrylic acid were added, and the mixture was further stirred for 2 hours. Thereafter, 50 g of methanol was added to stop the reaction. The resulting random copolymer was washed, filtered, and concentrated, and Copolymer 16 was obtained. The structures of the constituent units (a1), (a2), (a3), and (b) are as follows.

[Chem. 33]

a1 a2 a3 b

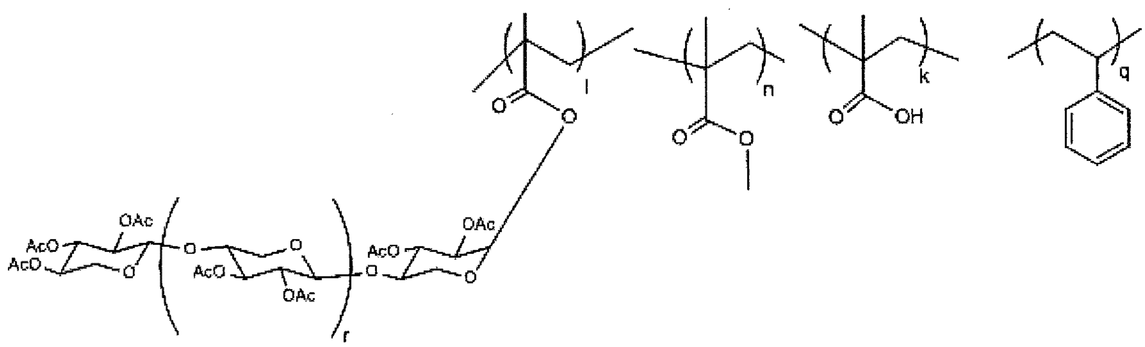

q = 47, n = 47, l = 47, k = 47, and r = 1

Synthesis of Copolymer 17

Synthesis of PS-Acetyl Saccharide Methacrylate 2-ran-methyl methacrylate-ran-methyl acrylate A PS-Acetyl Saccharide Methacrylate 2-ran-methyl methacrylate-ran-methyl acrylate random copolymer was synthesized in the same manner as in Copolymer 16 with the exception that 5 g of methacrylic acid was replaced with 10 g of methyl acrylate in the synthesis of the PS-Acetyl Saccharide Methacrylate 2-ran-methyl methacrylate-ran-methacrylate random copolymer. The structures of the constituent units a1, a2, a3, and b are as follows.

[Chem. 34]

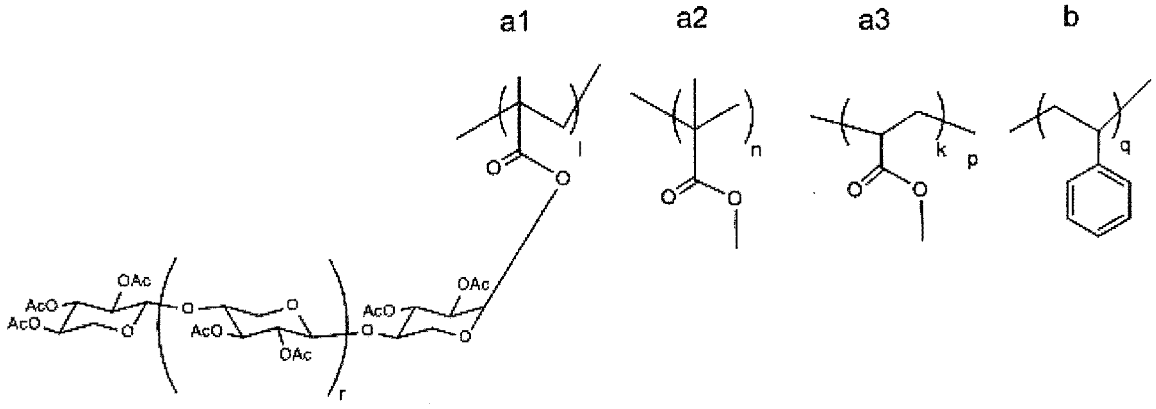

q = 47, n = 47, l = 47, k = 47, and r = 1

Synthesis of Copolymer 18

Synthesis of Acetyl Saccharide Methacrylate 7

First, 33 g of a xylooligosaccharide (average degree of polymerization of 4) was dissolved in 150 mL of water, and then 28.5 g each of ammonium hydrogen carbonate (available from Wako Pure Chemical Industries, Ltd.) was added every 24 hours four times, and the mixture was stirred at 37°C for 96 hours. Thereafter, 200 mL of distilled water was added, and water was distilled off until the volume of the mixture was reduced to 20 mL. Then 150 mL of water was added, and the mixture was concentrated to 10 mL. This operation was repeated until un ammonia odor was eliminated, and after lyophilization, a white solid was obtained. This substance was dissolved in 50 mL of 1 x $10^{-3}$ M KOH aqueous solution, 10.4 g of 2-isocyanate ethyl methacrylate (available from Wako Pure Chemical Industries, Ltd.) was added, and the mixture was stirred vigorously for 12 hours while the temperature was maintained at 3°C. A precipitated white solid was removed, and then the filtrate was washed four times with 50 mL of diethyl ether, and lyophilized. Thereafter, the resulting white solid was dissolved in a mixed solution of 2 mL of water and 10 mL of methanol. The solution was added dropwise to a mixed solution of 200 mL of acetone, and the mixed solution was cooled. Thereafter, the mixture was filtrated with a filter, the filtrate was dried under reduced pressure, and 2-(methacryloyloxy)ethylureido xylooligosaccharide was obtained. Then 120 g of acetic anhydride was allowed to react with 10 g of this saccharide methacrylate for 2 hours. Thereafter, the reaction was stopped with a 33% magnesium acetate solution. Purified water was added to the reaction mixture to precipitate a reaction product, and Acetyl Saccharide Methacrylate 7 was obtained.

[Chem. 35]

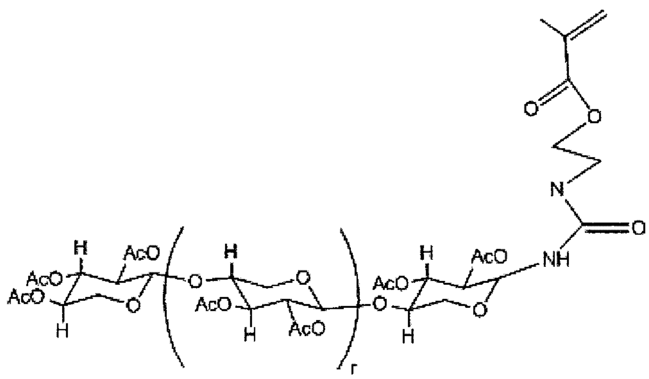

r = 2

Synthesis of PS-Acetyl Saccharide Methacrylate 7 random copolymer

A PS-Acetyl Saccharide Methacrylate 7 random copolymer was synthesized in the same manner as in the synthesis of Copolymer 1 with the exception that Acetyl Saccharide Methacrylate 1 was replaced with 15 g of Acetyl Saccharide Methacrylate 7 in the synthesis of the PS-Acetyl Saccharide Methacrylate 1 random copolymer. The structures of the constituent units (a) and (b) are as follows.

[Chem. 36]

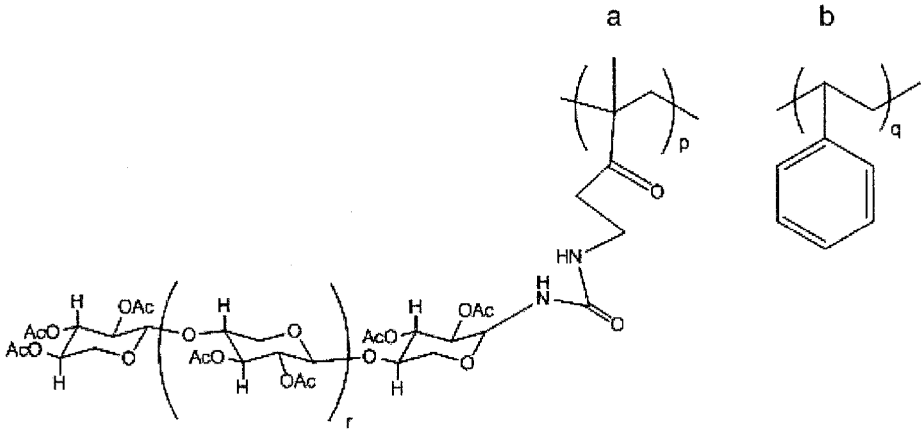

p = 40, q = 27, and r = 2

Synthesis of Copolymer 19

Polystyrene

An amino-terminated PS (Mw = 12300 Da, Mw/Mn = 1.02, available from Polymer Source Inc.) including the following structure was used as a polystyrene.

[Chem. 37]

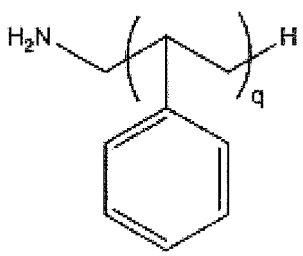

Synthesis of acetyl saccharide

To a mixed solution of 120 g of acetic anhydride and 150 g of pyridine, 10 g of a xylooligosaccharide (average saccharide chain length of 80) was added, and the mixture was stirred at 30°C for 17 hours. Approximately 5 times the amount of cold water as that of the solution was slowly added to the solution while the solution was stirred. The mixture was stirred for 30 minutes, and an acetyl saccharide, which was a xylose acetyl derivative, was synthesized.

Synthesis of PS-acetyl saccharide block copolymer: coupling reaction

The block copolymer was synthesized with reference to Macromolecules, Vol. 36, No. 6, 2003. First, 20 g of the acetyl saccharide and 400 mg of an amino-terminated PS were added in 100 mL of DMF, and then 80 mg of NaCNBH3 was added as a reducing agent. The mixture was stirred at 60°C for 7 days, during which 80 mg of NaCNBH3 was added

every day. The mixture was then cooled to room temperature, and 400 mL of water was added for precipitation. The precipitate was filtered and washed with cold water several times, and excess of the acetyl saccharide was removed. The filtered solid was then vacuum-dried, and 650 mg of an acetyl saccharide-polystyrene block copolymer (Copolymer 19), which was a beige powder, was obtained.

The structure of the copolymer contained in the resulting Copolymer 19 is as follows.

[Chem. 38]

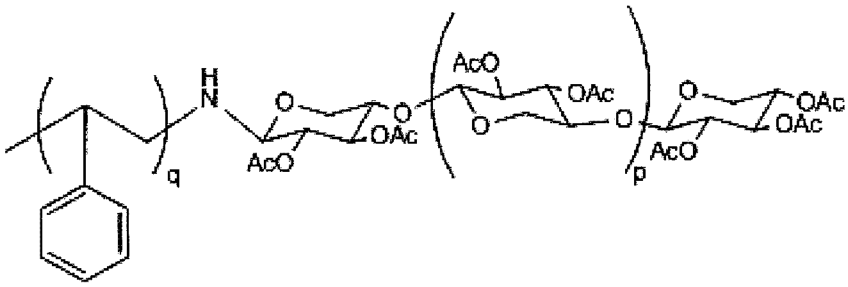

p = 131 and q = 154

Synthesis of Copolymer 20

Synthesis of PS-methyl methacrylate random copolymer

To a flask, 500 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added, and the mixture was stirred for 5 minutes and then dehydrated and degassed. Then 30 g of styrene and 30 g of methyl methacrylate were added, and the mixture was stirred for 30 minutes. Thereafter, 7 g of methanol was added to stop the reaction, and Copolymer 20 was obtained. The structures of the constituent units a and b are as follows.

[Chem. 39]

a

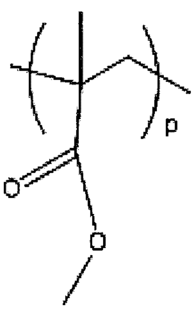

b

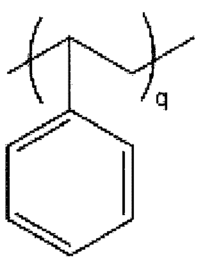

p = 50 and q = 448

Synthesis of Copolymer 21

Synthesis of PS-methyl methacrylate block copolymer

To a flask, 1000 mL of tetrahydrofuran and 92 g of a 2.6 mass% lithium chloride solution in THF (available from Tokyo Chemical Industry Co., Ltd.) were added, and the mixture was cooled to -78°C under an argon atmosphere. Then 13 g of a 15.4 mass% n-butyl lithium solution in hexane (available from Tokyo Chemical Industry Co., Ltd.) was added,

and the mixture was stirred for 5 minutes and then dehydrated and degassed. Next, 48 g of styrene was added, and the mixture was stirred for 1 hour. Then 1 g of diphenylethylene was further added, and the mixture was stirred for 5 minutes. Then 70 g of methyl methacrylate (available from Wako Pure Chemical Industries, Ltd.) was added, and the mixture was further stirred for 30 minutes. Thereafter, 14 g of methanol was added to stop the reaction. The resulting block copolymer was washed, filtered, and concentrated, and 55 g of a PS-methyl methacrylate block copolymer (Copolymer 21) was obtained.

[Chem. 40]

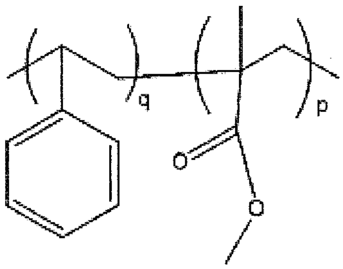

p = 245 and q = 245

Synthesis of polymer 22

Acetyl cyclodextrin

Triacetyl-β-cyclodextrin (available from Tokyo Chemical Industry Co., Ltd.), which is an acetyl cyclodextrin, was prepared as a polymer 22. The structure of the polymer 22 is as follows.

[Chem. 41]

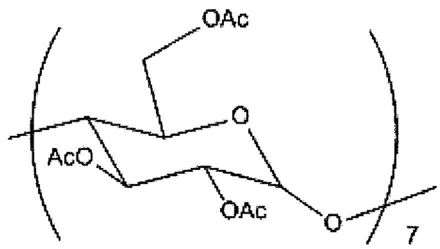

Analysis of copolymer

Weight average molecular weight

The weight average molecular weight of the copolymer was measured by gel permeation chromatogram (GPC) method.
GPC Column: Shodex K-806M/K-802 connected columns (available from Showa Denko K.K.)
Column temperature: 40°C
Moving bed: chloroform

Detector: RI

Note that, in synthesizing the block copolymer, first, a first block (polymer moiety (b)) was polymerized, then a portion of the reaction mixture was taken out, and the degree of polymerization was checked using the GPC method. Thereafter, the next block (polymer moiety a) was polymerized, and then the degree of polymerization was checked by the GPC method in the same manner. Thereby the formation of the block copolymer having the target degree of polymerization and average molecular weight was confirmed. In synthesizing the random copolymer, after all the polymerizations were completed, the degree of polymerization was checked by the GPC method, thereby the formation of the random copolymer having the target degree of polymerization and average molecular weight was confirmed.
The molecular weight of each copolymer was prepared to have a weight average molecular weight Mw of 50000.

Ratio of polymer moiety (a) (hydrophilic moiety):polymer moiety (b) (hydrophobic moiety)

The unit ratio (molar ratio) of the polymer moiety (a) and the polymer moiety (b) of the copolymer was determined by $^1$H-NMR and calculated.

Content ratio of saccharide derivative moiety

The content ratio of the saccharide derivative moiety was determined by the following formula.

Content ratio (mass%) of saccharide derivative moiety = degree of polymerization of saccharide-derived unit x molecular weight of saccharide derivative x unit number of degree of polymerization (a)/weight average molecular weight of copolymer

The unit number of the degree of polymerization (a) was calculated from the weight average molecular weight and the unit ratio of the copolymer, and the molecular weight of each structure.
The structure of each copolymer is summarized in Table 1 below.

Table 1

| | Constitution (a) | Constitution (b) | Polymer | Ratio (molar ratio) of constitution (a): constitution (b) | Content ratio (mass%) of saccharide derivative moiety |
|---|---|---|---|---|---|
| Copolymer 1 | Acetyl Saccharide Methacrylate 1 | Styrene | Random | 90:10 | 72 |
| Copolymer 2 | Acetyl Saccharide Methacrylate 2 | Styrene | Random | 90:10 | 76 |
| Copolymer 3 | Acetyl Saccharide Methacrylate 3 | Methyl methacrylate | Random | 10:90 | 53 |
| Copolymer 4 | Acetyl Saccharide Methacrylate 4 | Vinylnaphthalene | Random | 30:70 | 67 |
| Copolymer 5 | Acetyl saccharide styrene | Styrene | Random | 50:50 | 75 |
| Copolymer 6 | Acetyl Saccharide Methacrylate 5 | Lactic acid | Block | 40:60 | 53 |
| Copolymer 7 | Acetyl Saccharide Methacrylate 1 | Styrene | Block | 5:95 | 10 |
| Copolymer 8 | Acetyl saccharide methacrylate-ran-methyl methacrylate | Styrene | Block | 20:80 | 6 |
| Copolymer 9 | Acetyl Saccharide Methacrylate 6 | Styrene | Block | 20:80 | 19 |
| Copolymer 10 | Acetyl saccharide acrylate | Styrene | Random | 90:10 | 75 |

(continued)

| | Constitution (a) | Constitution (b) | Polymer | Ratio (molar ratio) of constitution (a): constitution (b) | Content ratio (mass%) of saccharide derivative moiety |
|---|---|---|---|---|---|
| Copolymer 11 | Acetyl saccharide acrylate-ran-methyl acrylate | Styrene | Random | 90:10 | 78 |
| Copolymer 12 | Acetyl saccharide acrylate-ran-acrylate | Styrene | Random | 70:30 | 58 |
| Copolymer 13 | Acetyl saccharide acrylate - ran-methacrylate | Styrene | Random | 90:10 | 79 |
| Copolymer 14 | Acetyl saccharide acrylate-ran-methacrylate chloride | Styrene | Random | 70:30 | 83 |
| Copolymer 15 | Acetyl saccharide ethyl methacrylate-ran-hydroxyethyl methacrylate | Styrene | Random | 50:50 | 38 |
| Copolymer 16 | Acetyl saccharide methacrylate-ran-methyl methacrylate-ran-methacrylate | Styrene | Random | 25:75 | 65 |
| Copolymer 17 | Acetyl saccharide methacrylate-ran-methyl methacrylate-ran-methyl acrylate | Styrene | Random | 25:75 | 65 |
| Copolymer 18 | Acetyl Saccharide Methacrylate 7 | Styrene | Random | 60:40 | 72 |
| Copolymer 19 | Acetyl saccharide | Styrene | Block | 46:54 | 68 |
| Copolymer 20 | Methyl methacrylate | Styrene | Random | 90:10 | 0 |
| Copolymer 21 | Methyl methacrylate | Styrene | Block | 50:50 | 0 |
| Polymer 22 | Acetyl dextrin | - | - | - | 100 |

Synthesis of saccharide derivatives

Synthesis of Saccharide Derivative 1

First, 10 g of xylotriose was dissolved in 110 g of pyridine, and then 70 g of acetic anhydride was added and allowed to react at 30°C for 17 hours. After completion of the reaction, 500 g of cold water was added, and a white xylotriose acetyl derivative (Saccharide Derivative 1) was obtained. FT-IR confirmed that the absorption spectrum near 3200 $cm^{-1}$ derived from the -OH group disappeared, and the absorption spectrum near 1752 $cm^{-1}$ derived from the C=O group appeared. The structure of Saccharide Derivative 1 is as shown in the following structural formula with n = 1.

[Chem. 42]

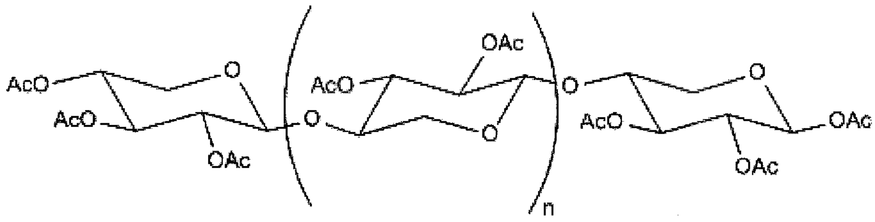

Synthesis of Saccharide Derivative 2

Saccharide Derivative 2, which is a xyloheptaose acetyl derivative, was obtained by the same synthesis method as in the synthesis of Saccharide Derivative 1 with the exception that the raw material was changed from 10 g of xylotriose to 10 g of xyloheptaose. The structure of Saccharide Derivative 1 is as shown in the above structural formula with n = 3.

Synthesis of Saccharide Derivative 3

Saccharide Derivative 3, which is a xylodecaose propyl derivative, was obtained by the same synthesis method as in the synthesis of Saccharide Derivative 1 with the exception that the raw material was changed from 10 g of xylotriose to 10 g of xylodecaose, and 70 g of acetic anhydride was changed to 100 g of propionic anhydride. The structure of Saccharide Derivative 3 is as shown in the following structural formula with n = 8.

[Chem. 43]

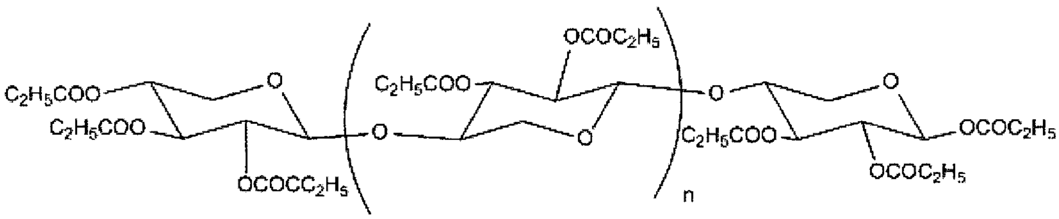

Synthesis of Saccharide Derivative 4

Saccharide Derivative 4, which is a glucose acetyl derivative, was obtained by the same synthesis method as in the synthesis of Saccharide Derivative 1 with the exception that the raw material was changed from 10 g of xylotriose to 12 g of glucose, 70 g of acetic anhydride was changed to 120 g of benzoic anhydride, and 500 g of cold water was changed to 300 g of diethyl ether. The structure of Saccharide Derivative 4 is the following structure.

[Chem. 44]

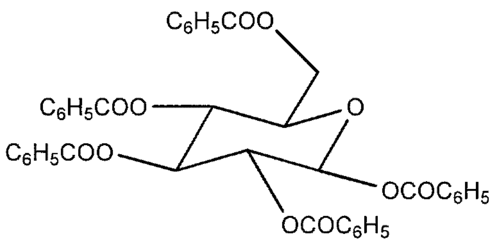

The structure of each saccharide derivative is summarized in Table 2 below.

[Table 2]

| | Structure of monosaccharide | Saccharide chain length | Derivative |
|---|---|---|---|
| Saccharide Derivative 1 | Xylose | 3 | Acetyl |
| Saccharide Derivative 2 | Xylose | 5 | Acetyl |
| Saccharide Derivative 3 | Xylose | 10 | Propyl |
| Saccharide Derivative 4 | Glucose | 1 | Benzoyl |

Cross-linking compound

As a cross-linking compound, 1,3,4,6-tetrakis(methoxymethyl)glycoluril (available from Tokyo Chemical Industry Co., Ltd.) was provided.

[Chem. 45]

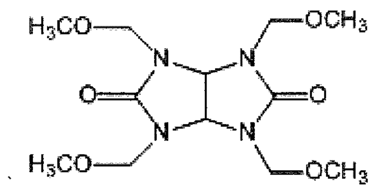

Anti-light reflection agent

As an anti-light-reflection agent, 2-methoxybenzoic acid (available from Tokyo Chemical Industry Co., Ltd.) was provided.

[Chem. 46]

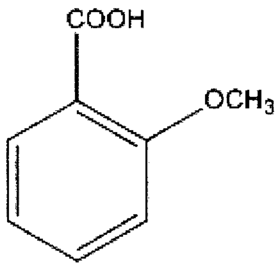

Evaluation of copolymer

Calculation of solubility of copolymer

First, 0.1 g of the copolymer was weighed and placed in a sample bottle, and PGMEA as an organic solvent was gradually added (the organic solvent was added up to 19.9 g) while the mixture was stirred. The liquid temperature of the organic solvent was adjusted to 25°C. The copolymer was considered to be dissolved when the solution became visually clear, and the solubility of the copolymer was calculated from the mass of the organic solvent added.

Solubility of copolymer (%) = mass of copolymer/mass of organic solvent when copolymer is dissolved x 100

The results obtained are listed in Table 3 below. The solubility of the copolymer at 1% or higher was evaluated as good. The solubility of the copolymer is more preferably 2% or higher, even more preferably 3% or higher, and particularly

preferably 4% or higher.

Examples 1 to 25 and Comparative Examples 1 to 3

Preparation of underlayer film-forming composition sample

First, 50 mg of the copolymer and an additive listed in Table 3 below (a saccharide derivative, a cross-linking compound, or an anti-light-reflection agent) were dissolved in 1 mL of PGMEA, and then an underlayer film-forming composition sample of each example and comparative example. When a saccharide derivative was added, it was added to give a solid weight of 10 mass% relative to the total mass of the copolymer.

When a cross-linking compound was added, it was added to give a solid weight of 2 mass% relative to the total mass of the copolymer.

When an anti-light-reflection agent was added, it was added to give a solid weight of 5 mass% relative to the total mass of the copolymer.

Evaluation of metal introduction rate in underlayer film-forming composition The resulting underlayer film-forming composition was spin-coated on a 2-inch silicon wafer substrate. The underlayer film-forming composition was coated to give a film thickness of 200 nm, then the coated substrate was calcined on a hot plate at 230°C for 5 minutes, and an underlayer film sample was formed.

The underlayer film sample thus formed was placed in an atomic layer deposition device (ALD: SUNALE R-100B available from PICUSAN), $Al(CH_3)_3$ gas was introduced at 95°C, and steam was introduced. This operation was repeated three times to introduce $Al_2O_3$ into the underlayer film. An energy-dispersive X-ray analysis (EDX analysis) was performed on the underlayer film after the $Al_2O_3$ introduction with an electronic microscope JSM7800F (available from JEOL Ltd.), and the ratio of the Al component was calculated.

The results obtained are listed in Table 3 below. The metal introduction rate at 5% or higher was evaluated as good. The metal introduction rate is more preferably 10% or higher, even more preferably 20% or higher, and particularly preferably 25% or higher.

Calculation of coated film residual rate

The resulting underlayer film-forming composition was spin-coated on a 2-inch silicon wafer substrate. The underlayer film-forming composition was coated to give a film thickness of 200 nm, then the coated substrate was calcined on a hot plate at 210°C for 2 minutes, and an underlayer film sample was formed.

The underlayer film sample before washing and coated with the underlayer film-forming composition, was coated with propylene glycol monomethyl ether acetate, which is a solvent used for a photoresist, with a spin coater at 1000 rpm for 30 seconds and washed. Thereafter, the film was calcined on a hot plate at 210°C in the atmosphere for 2 minutes, and an underlayer film after washing was obtained.

The coated film thicknesses before and after washing were measured with a step gauge, and the coated film residual rate was determined as follows.

$$\text{Coated film residual rate (\%)} = \text{film thickness (µm) of underlayer film after washing/film thickness (µm) of underlayer film before washing} \times 100$$

The results obtained are listed in Table 3 below. The coated film residual rate at 80% or higher was evaluated as good. The coated film residual rate is more preferably 85% or higher, even more preferably 90% or higher, and particularly preferably 95% or higher.

Evaluation of cracking resistance

The resulting underlayer film-forming composition was spin-coated on a 2-inch silicon wafer substrate. The underlayer film-forming composition was coated to give a film thickness of 200 nm, then the coated substrate was calcined on a hot plate at 210°C for 2 minutes, and an underlayer film sample was formed.

A photoresist for an ArF excimer laser lithography was spin-coated on the underlayer film sample. The photoresist was coated to give a film thickness of 150 nm, and then the coated underlayer film sample was calcined on a hot plate at 100°C for 1 minute. Upon the calcination, occurrence of cracking on the coated film was visually observed.

Good: No cracking occurred (the surface was in a uniform state)

Poor: Cracking occurred (cracking can be observed on the surface)

Evaluation of etching processability

The resulting underlayer film-forming composition was spin-coated on a 2-inch silicon wafer substrate. The underlayer film-forming composition was coated to give a film thickness of 200 nm, then the coated substrate was calcined on a hot plate at 210°C for 2 minutes, and an underlayer film sample was formed.
The underlayer film sample was masked in a line-and-space format (a line width of 50 nm and a space width of 50 nm) and exposed to light with an ArF excimer laser exposure machine. Thereafter, the underlayer film sample was calcined on a hot plate at 60°C for 1 minute, then a developing solution was immersed, thereby a line-and-space pattern was formed.
The substrate was subjected to oxygen plasma treatment (100 sccm, 4 Pa, 100 W, and 300 seconds) using an ICP plasma etching apparatus (available from Tokyo Electron Limited.), thereby the photoresist was removed, and a line-and-space pattern was formed on the underlayer film. Thereafter, a metal was introduced into the underlayer film sample in the same manner as in the evaluation of the metal introduction rate in the base film-forming composition. This pattern was used as a mask, and a silicon substrate was etched using trifluoromethane gas.
The pattern-formed surface of the trifluoromethane-treated substrate was observed with a scanning electron microscope (SEM) JSM7800F (available from JEOL Ltd.) at an accelerating voltage of 1.5 kV, an emission current of 37.0 μA, and a magnification of 100000, thereby the state of the etching processability was observed. The state of the etching processability was evaluated based on the following evaluation criteria.
Good: The pattern is in a state where there is no collapse of the line in one field of view of SEM.
Poor: The pattern is in a state where a line is collapsed or distorted at least in a part of the pattern. The results obtained are listed in Table 3 below.

[Table 3]

| | Copolymer | Saccharide derivative | Cross-linking compound | Anti-light-reflection agent | Solubility | Coated film residual rate | Metal introduction rate | Cracking resistance | Etching processability |
|---|---|---|---|---|---|---|---|---|---|
| Example 1 | Copolymer 1 | No | No | No | 3.0% | 85% | 28% | Good | Good |
| Example 2 | Copolymer 2 | No | No | No | 6.2% | 82% | 23% | Good | Good |
| Example 3 | Copolymer 3 | No | No | No | 2.3% | 80% | 25% | Good | Good |
| Example 4 | Copolymer 4 | No | No | No | 3.3% | 89% | 23% | Good | Good |
| Example 5 | Copolymer 5 | No | No | No | 2.2% | 80% | 30% | Good | Good |
| Example 6 | Copolymer 6 | No | No | No | 4.3% | 85% | 26% | Good | Good |
| Example 7 | Copolymer 7 | No | No | No | 4.0% | 81% | 15% | Good | Good |
| Example 8 | Copolymer 8 | No | No | No | 7.0% | 84% | 8% | Good | Good |
| Example 9 | Copolymer 9 | No | No | No | 2.5% | 82% | 20% | Good | Good |
| Example 10 | Copolymer 10 | No | No | No | 2.5% | 81% | 25% | Good | Good |
| Example 11 | Copolymer 11 | No | No | No | 3.1% | 83% | 26% | Good | Good |
| Example 12 | Copolymer 12 | No | No | No | 2.1% | 81% | 15% | Good | Good |
| Example 13 | Copolymer 13 | No | No | No | 2.2% | 84% | 22% | Good | Good |
| Example 14 | Copolymer 14 | No | No | No | 2.0% | 80% | 11% | Good | Good |

(continued)

| | Copolymer | Saccharide derivative | Cross-linking compound | Anti-light-reflection agent | Solubility | Coated film residual rate | Metal introduction rate | Cracking resistance | Etching processability |
|---|---|---|---|---|---|---|---|---|---|
| Example 15 | Copolymer 15 | No | No | No | 12.0% | 80% | 22% | Good | Good |
| Example 16 | Copolymer 16 | No | No | No | 5.5% | 85% | 23% | Good | Good |
| Example 17 | Copolymer 17 | No | No | No | 6.0% | 88% | 23% | Good | Good |
| Example 18 | Copolymer 18 | No | No | No | 3.3% | 83% | 24% | Good | Good |
| Example 19 | Copolymer 19 | No | No | No | 2.1% | 81% | 30% | Good | Good |
| Example 11 | Copolymer 1 | Saccharide Derivative 1 | No | No | 3.0% | 90% | 35% | Good | Good |
| Example 12 | Copolymer 1 | Saccharide Derivative 2 | No | No | 3.0% | 93% | 37% | Good | Good |
| Example 13 | Copolymer 1 | Saccharide Derivative 3 | No | No | 3.0% | 98% | 31% | Good | Good |
| Example 14 | Copolymer 1 | Saccharide Derivative 4 | No | No | 3.0% | 91% | 29% | Good | Good |
| Example 15 | Copolymer 1 | Saccharide Derivative 1 | Yes | No | 3.0% | 95% | 34% | Good | Good |
| Example 16 | Copolymer 1 | Saccharide Derivative 1 | Yes | Yes | 3.0% | 95% | 34% | Good | Good |
| Comparative Example 1 | Copolymer 20 | No | No | No | 6.5% | 70% | 3% | Good | Poor |
| Comparative Example 2 | Copolymer 21 | Saccharide Derivative 1 | Yes | No | 7.1% | 77% | 4% | Good | Poor |
| Comparative Example 3 | Polymer 22 | No | Yes | No | 0.7% | 65% | 15% | Poor | Good |

As shown in Table 3, the underlayer film-forming composition of each example exhibited high solubility of the copolymer in the organic solvent. In addition, the underlayer film-forming composition of each example was able to form an underlayer film not prone to cracking under the atmosphere and by heat treatment at a relatively low temperature and having a high coated film residual rate. Furthermore, Examples 20 to 20 revealed that the underlayer film-forming composition containing a saccharide derivative can provide an underlayer film having further high coated film residual rate. Moreover, Examples 24 and 25 revealed that the underlayer film-forming composition containing a cross-linking compound can provide an underlayer film having further higher coated film residual rate. Note that all examples exhibited high metal introduction rate and good etching processability.

Comparative Examples 1 and 2 resulted in low coated film residual rate. Note that Comparative Examples 1 and 2 exhibited low metal introduction rate and poor etching processability. Comparative Example 3 resulted in low solubility of the copolymer in the organic solvent. Note that, as a result of the low solubility of the copolymer, the coated film failed to have an adequate film thickness.

## Claims

1. An underlayer film-forming composition for forming an underlayer film used for pattern formation, which comprises a copolymer and an organic solvent;
the copolymer comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and
the polymer moiety (b) comprises no saccharide derivative moiety.

2. The underlayer film-forming composition according to claim 1, wherein the saccharide derivative moiety is a cellulose derivative moiety, a hemicellulose derivative moiety, or a xylooligosaccharide derivative moiety.

3. The underlayer film-forming composition according to claim 1 or 2, which further comprises a saccharide derivative.

4. The underlayer film-forming composition according to any one of claims 1 to 3, which further comprises a cross-linking compound.

5. The underlayer film-forming composition according to any one of claims 1 to 4, which further comprises an anti-light-reflection agent.

6. The underlayer film-forming composition according to any one of claims 1 to 5, which further comprises introducing a metal when used for the pattern formation.

7. A pattern-forming method, which comprises forming an underlayer film using the underlayer film-forming composition described in any one of claims 1 to 6.

8. The pattern-forming method according to claim 7, which further comprises introducing a metal into the underlayer film.

9. A copolymer for forming an underlayer film used for pattern formation, which comprises a polymer moiety (a) and a polymer moiety (b);
the polymer moiety (a) comprises a saccharide derivative moiety;
the saccharide derivative moiety is at least one of a pentose derivative moiety or a hexose derivative moiety; and
the polymer moiety (b) comprises no saccharide derivative moiety.

**INTERNATIONAL SEARCH REPORT**

International application No. PCT/JP2017/045804

A. CLASSIFICATION OF SUBJECT MATTER
Int.Cl. G03F7/11(2006.01)i

According to International Patent Classification (IPC) or to both national classification and IPC

B. FIELDS SEARCHED

Minimum documentation searched (classification system followed by classification symbols)
Int.Cl. G03F7/11

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2011/021398 A1 (IDEMITSU KOSAN CO., LTD.) 24 February 2011, paragraphs [0080]-[0085], [0110], [0112], embodiment 11<br>& TW 201120063 A | 1, 7, 9<br>4-5<br>2-3, 6, 8 |
| Y<br>A | JP 2007-017950 A (SHIN ETSU CHEMICAL CO., LTD.) 25 January 2007, paragraph [0041]<br>(Family: none) | 4<br>1-3, 5-9 |
| Y<br>A | WO 2005/022261 A1 (NISSAN CHEMICAL INDUSTRIES, LTD.) 10 March 2005, paragraphs [0002], [0026], [0027]<br>& US 2007/0004228 A1, paragraphs [0002]-[0005], [0058]-[0062] & EP 1666972 A1 & CN 1842744 A & TW 200508806 A & KR 10-1113775 B1 | 5<br>1-4, 6-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
23.02.2018

Date of mailing of the international search report
06.03.2018

Name and mailing address of the ISA/
Japan Patent Office
3-4-3, Kasumigaseki, Chiyoda-ku,
Tokyo 100-8915, Japan

Authorized officer

Telephone No.

Form PCT/ISA/210 (second sheet) (January 2015)

**INTERNATIONAL SEARCH REPORT**

International application No.
PCT/JP2017/045804

C (Continuation). DOCUMENTS CONSIDERED TO BE RELEVANT

| Category* | Citation of document, with indication, where appropriate, of the relevant passages | Relevant to claim No. |
|---|---|---|
| A | WO 2009/104643 A1 (NISSAN CHEMICAL INDUSTRIES, LTD.) 27 August 2009, paragraphs [0025], [0068]-[0072], embodiments 1-5<br>& TW 200944944 A | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016170338 A
- JP 2016206676 A
- WO 2005043248 A
- JP 2007256773 A
- JP 2012100546 A
- JP 2012180424 A
- JP 2014148629 A


### Non-patent literature cited in the description


- *Macromolecules,* 2003, vol. 36 (6
- Material Matters. Latest Polymer Synthesis. Sigma-Aldrich Japan Ltd, vol. 5
- *Jornal of Photopolymer Science and Technology,* 2016, vol. 29 (5), 653-657